(19) Europäisches Patentamt
European Patent Office
Office européen des brevets

(11) EP 4 063 784 A1

(12) # EUROPEAN PATENT APPLICATION
published in accordance with Art. 153(4) EPC

(43) Date of publication:
**28.09.2022 Bulletin 2022/39**

(21) Application number: **20889716.5**

(22) Date of filing: **19.11.2020**

(51) International Patent Classification (IPC):
***G01C 3/06*** *(2006.01)* ***H01L 27/146*** *(2006.01)*
***H04N 5/357*** *(2011.01)* ***H04N 5/369*** *(2011.01)*
***H04N 5/3745*** *(2011.01)* ***G01S 7/487*** *(2006.01)*
***G01S 17/89*** *(2020.01)* ***G01S 17/93*** *(2020.01)*

(52) Cooperative Patent Classification (CPC):
**G01C 3/06; G01S 7/487; G01S 17/89; G01S 17/93; H01L 27/146; H04N 5/357; H04N 5/369; H04N 5/3745**

(86) International application number:
**PCT/JP2020/043269**

(87) International publication number:
**WO 2021/100826 (27.05.2021 Gazette 2021/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.11.2019 JP 2019209174**

(71) Applicant: **Sony Semiconductor Solutions Corporation**
**Atsugi-shi Kanagawa 243-0014 (JP)**

(72) Inventors:
- **MURASE, Takuro**
  **Atsugi-shi, Kanagawa 243-0014 (JP)**
- **OTAKE ,Yusuke**
  **Atsugi-shi, Kanagawa 243-0014 (JP)**
- **WAKANO, Toshifumi**
  **Atsugi-shi, Kanagawa 243-0014 (JP)**

(74) Representative: **Müller Hoffmann & Partner Patentanwälte mbB**
**St.-Martin-Strasse 58**
**81541 München (DE)**

(54) **LIGHT RECEIVING ELEMENT, AND RANGING MODULE**

(57) Disclosed herein is a ranging module including a light receiving element, a light emitting unit, and a light-emission control unit. The light receiving element has plural transfer gates which distribute and transfer, to plural floating diffusions, signal charge accumulated in a photodiode that photoelectrically converts incident light, and at least two of the plural transfer gates are disposed point-symmetrically with respect to an optical center as seen from a direction of incidence of the light. The light emitting unit emits irradiation light having a periodically varying brightness. The light-emission control unit controls irradiation timing of the irradiation light.

FIG.3

OFG
TGA
TGC
OFG
OFG
PD
OPC
TGD
TGB
OFG
10A

EP 4 063 784 A1

## Description

[Technical Field]

The technology according to the present disclosure (the present technology) relates to a light receiving element forming a gate type indirect ToF (Time of Flight), for example, and a ranging module including the light receiving element.

[Background Art]

As a light receiving element forming the gate type indirect ToF method (which may be referred to as a "gate type indirect ToF sensor" in the following description), for example, there is a configuration disclosed in PTL 1. In the gate type indirect ToF sensor disclosed in PTL 1, each floating diffusion is sandwiched between transfer gates of different transfer transistors in a pixel having plural floating diffusions in a unit pixel.

[Citation List]

[Patent Literature]

[PTL 1] Japanese Patent Laid-open No. 2019-001494

[Summary]

[Technical Problem]

However, the technology disclosed in PTL 1 has a problem that parasitic light sensitivity is not uniformly reduced because plural transfer gates between which the floating diffusion is sandwiched are arranged line-symmetrically with respect to an optical center.

In view of the above problem, an object of the present technology is to provide a light receiving element and a ranging module capable of uniformly reducing the parasitic light sensitivity.

[Solution to Problem]

A light receiving element according to one aspect of the present technology includes plural transfer gates that distribute and transfer, to plural floating diffusions, signal charge accumulated in a photodiode that performs photoelectrical conversion of incident light. Further, at least two of the plural transfer gates are arranged point-symmetrically with respect to an optical center when viewed from an incident direction of the light.

A ranging module according to one aspect of the present technology includes a light receiving element including plural transfer gates, a light emitting unit that emits irradiation light whose brightness changes periodically, and a light emission control unit that controls irradiation timing of the irradiation light. The plural transfer gates distribute and transfer, to plural floating diffusions, signal charge accumulated in a photodiode that performs photoelectrical conversion of incident light. Further, at least two of the plural transfer gates are arranged point-symmetrically with respect to an optical center when viewed from an incident direction of the light.

[Brief Description of Drawings]

[FIG. 1]

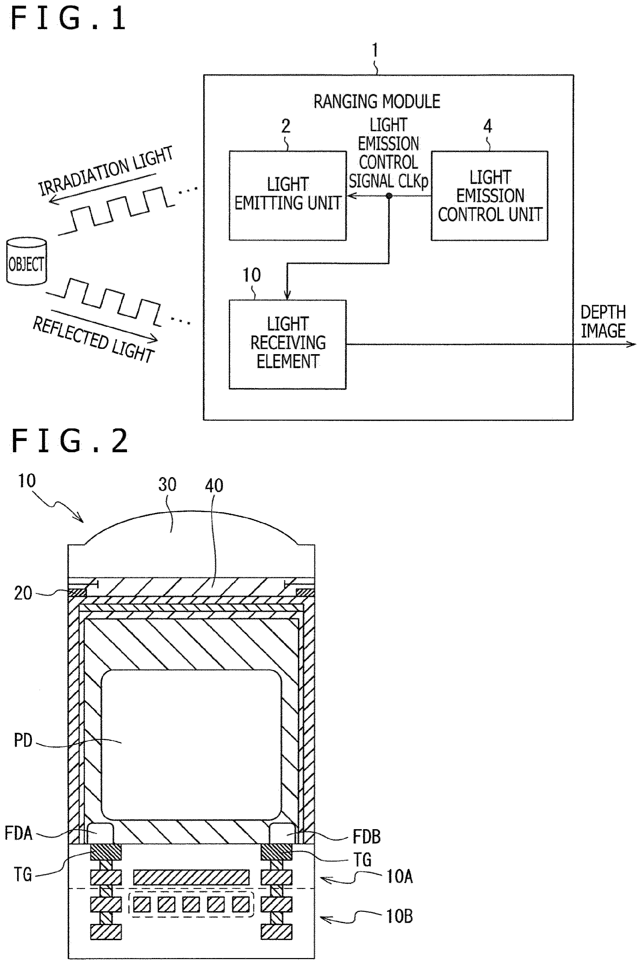

FIG. 1 is a block diagram depicting a configuration example of a ranging module according to a first embodiment.
[FIG. 2]
FIG. 2 is a cross-sectional view depicting a schematic configuration of a light receiving element according to the first embodiment.
[FIG. 3]

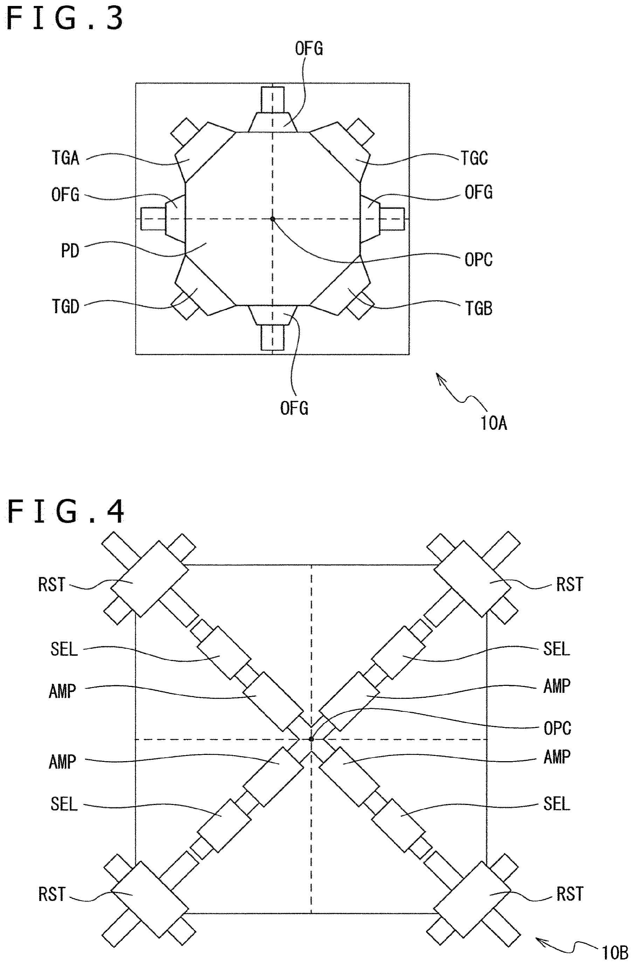

FIG. 3 is a plan view depicting a configuration of a first semiconductor layer.
[FIG. 4]
FIG. 4 is a plan view depicting a configuration of a second semiconductor layer.
[FIG. 5]

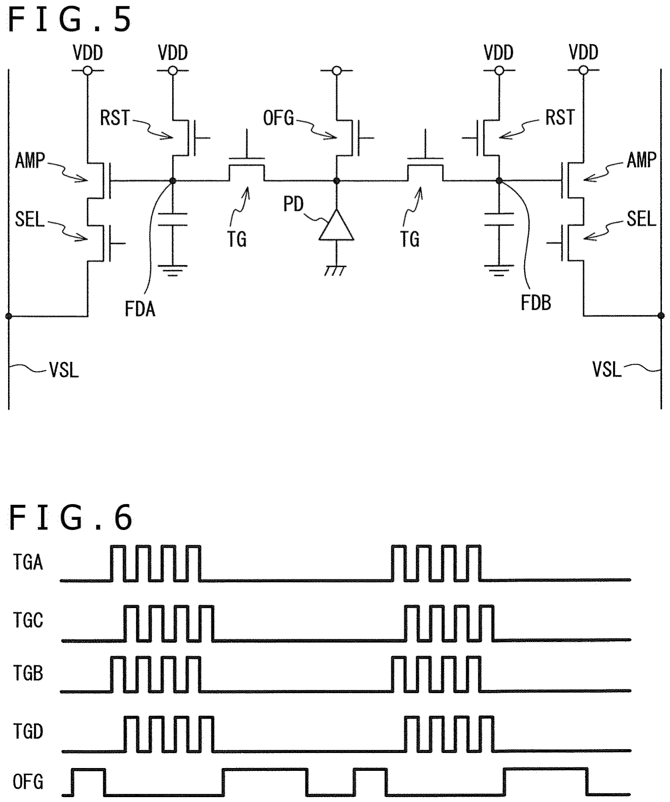

FIG. 5 is a diagram depicting a circuit configuration of the light receiving element.

[FIG. 6]
FIG. 6 is a timing chart depicting operations of transfer gates and an overflow gate.
[FIG. 7]

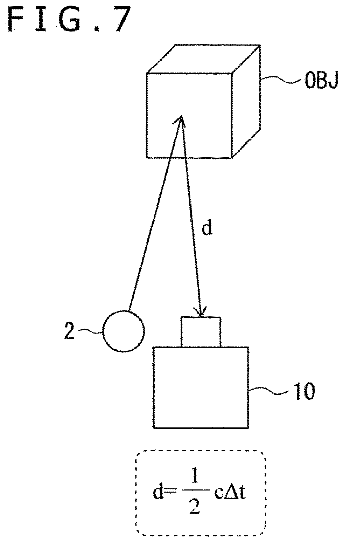

FIG. 7 is a diagram depicting an outline of a distance measurement process by a ToF method.
[FIG. 8]

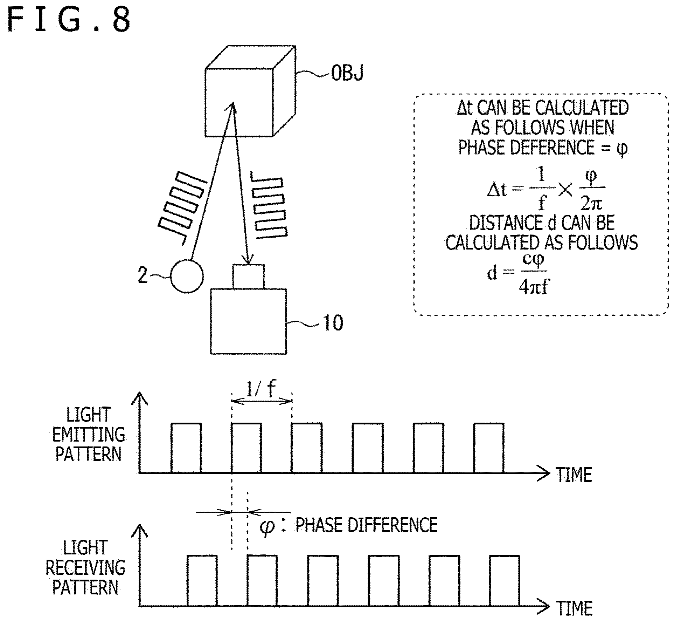

FIG. 8 is a diagram depicting the outline of the distance measurement process by the ToF method.
[FIG. 9]

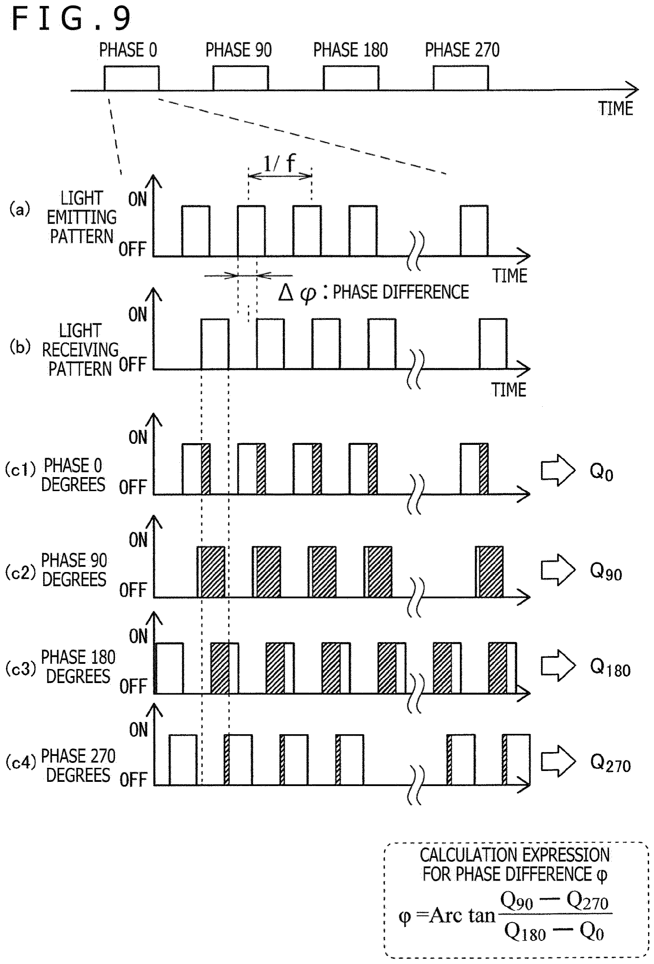

FIG. 9 is a diagram depicting the outline of the distance measurement process by the ToF method.
[FIG. 10]

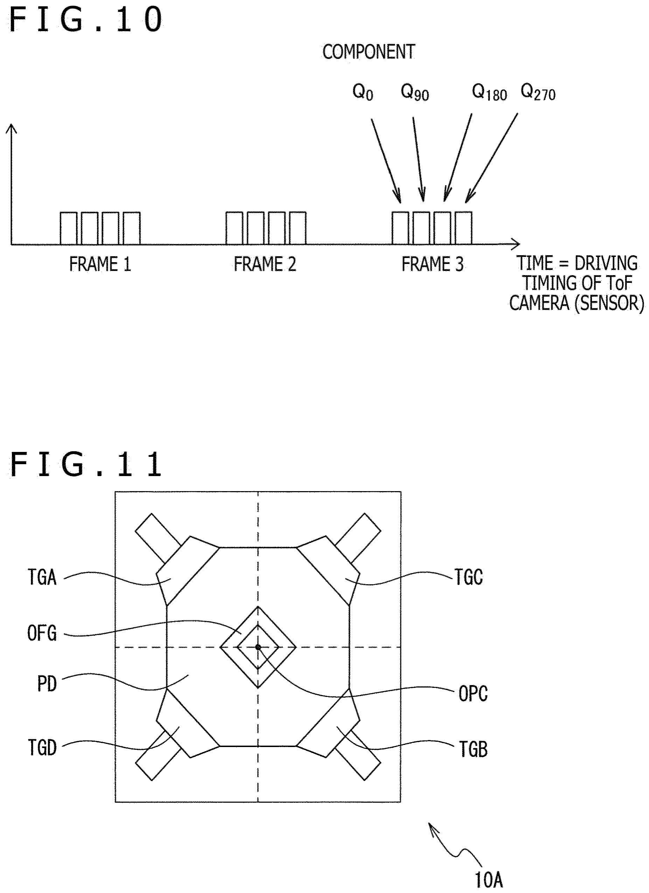

FIG. 10 is a diagram depicting the outline of the distance measurement process by the ToF method.
[FIG. 11]
FIG. 11 is a plan view depicting a configuration of a light receiving element according to a modification example of the first embodiment.
[FIG. 12]

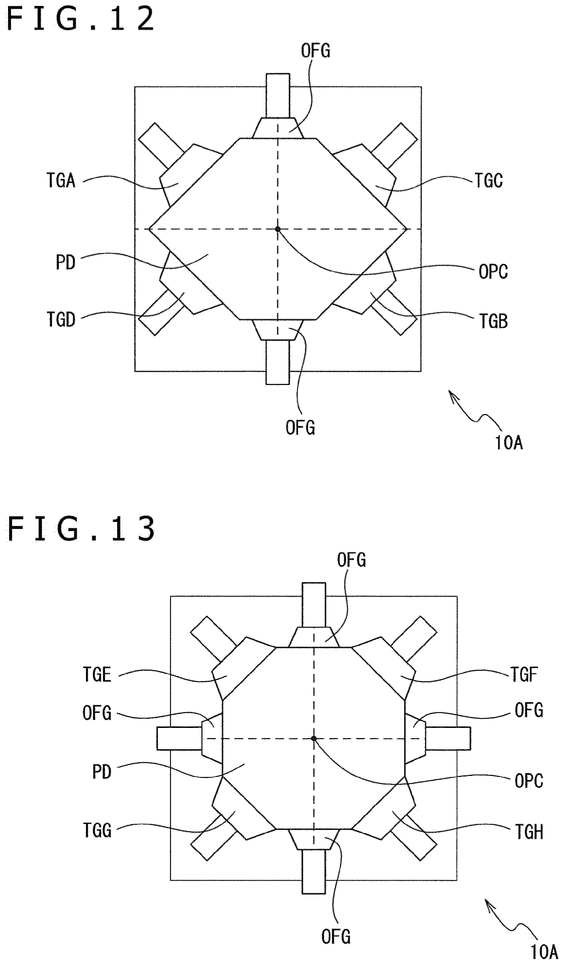

FIG. 12 is a plan view depicting a configuration of a light receiving element according to a modification example of the first embodiment.
[FIG. 13]
FIG. 13 is a plan view depicting a configuration of a light receiving element according to a modification example of the first embodiment.
[FIG. 14]

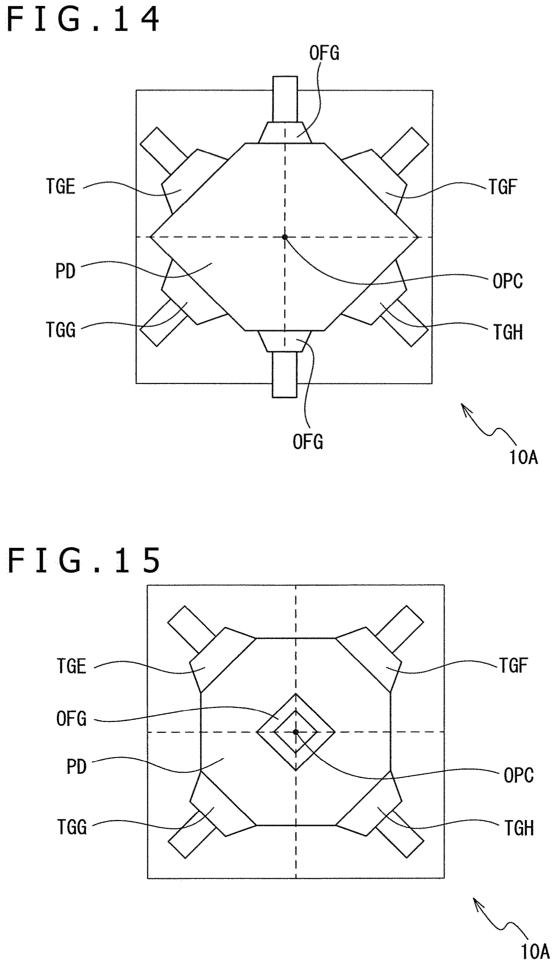

FIG. 14 is a plan view depicting a configuration of a light receiving element according to a modification example of the first embodiment.
[FIG. 15]
FIG. 15 is a plan view depicting a configuration of a light receiving element according to a modification example of the first embodiment.
[FIG. 16]

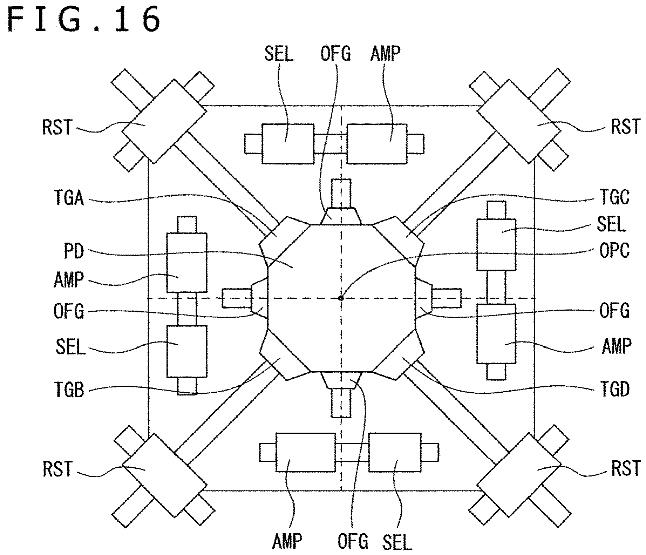

FIG. 16 is a plan view depicting a configuration of a light receiving element according to a modification example of the first embodiment.
[FIG. 17]

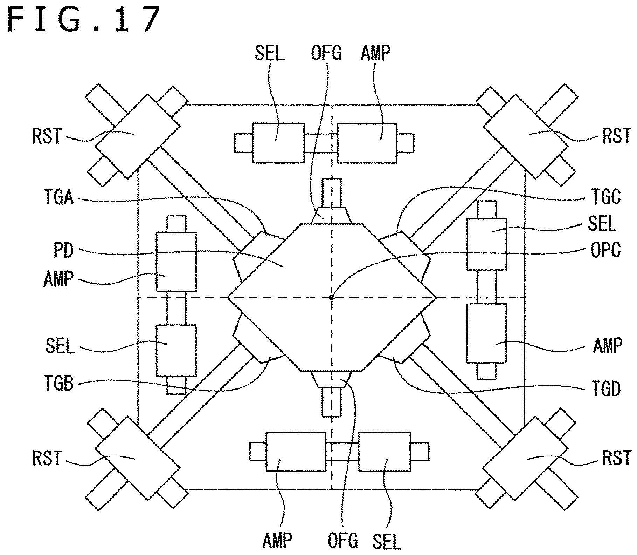

FIG. 17 is a plan view depicting a configuration of a light receiving element according to a modification example of the first embodiment.
[FIG. 18]

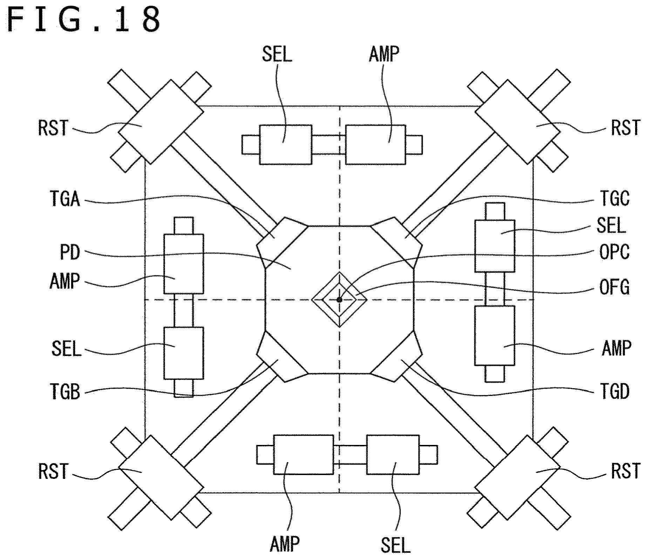

FIG. 18 is a plan view depicting a configuration of a light receiving element according to a modification example of the first embodiment.
[FIG. 19]

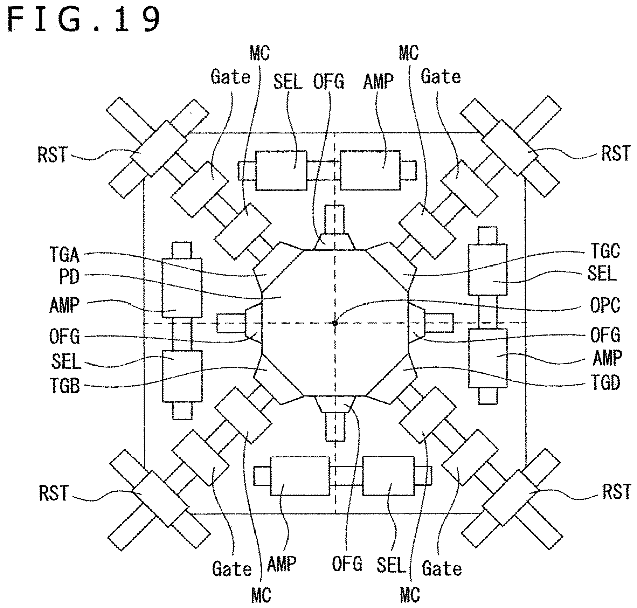

FIG. 19 is a plan view depicting a configuration of a light receiving element according to a modification example of the first embodiment.
[FIG. 20]

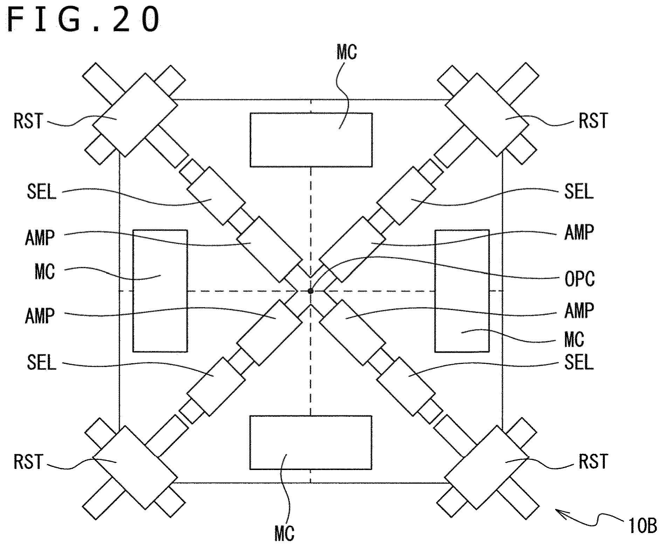

FIG. 20 is a plan view depicting a configuration of a light receiving element according to a modification example of the first embodiment.
[FIG. 21]

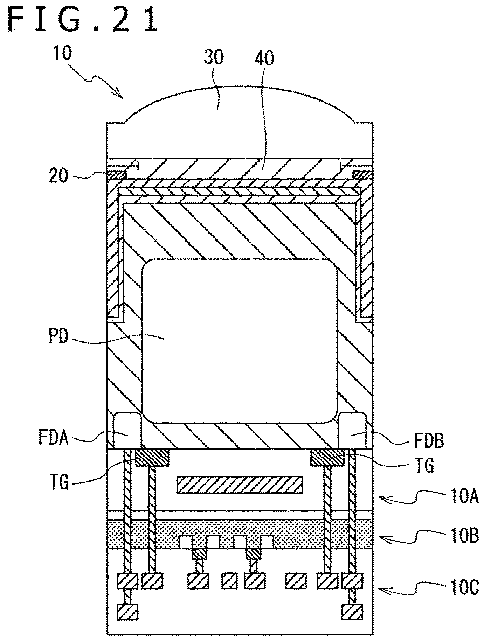

FIG. 21 is a cross-sectional view depicting a schematic configuration of a light receiving element according to a modification example of the first embodiment.
[FIG. 22]

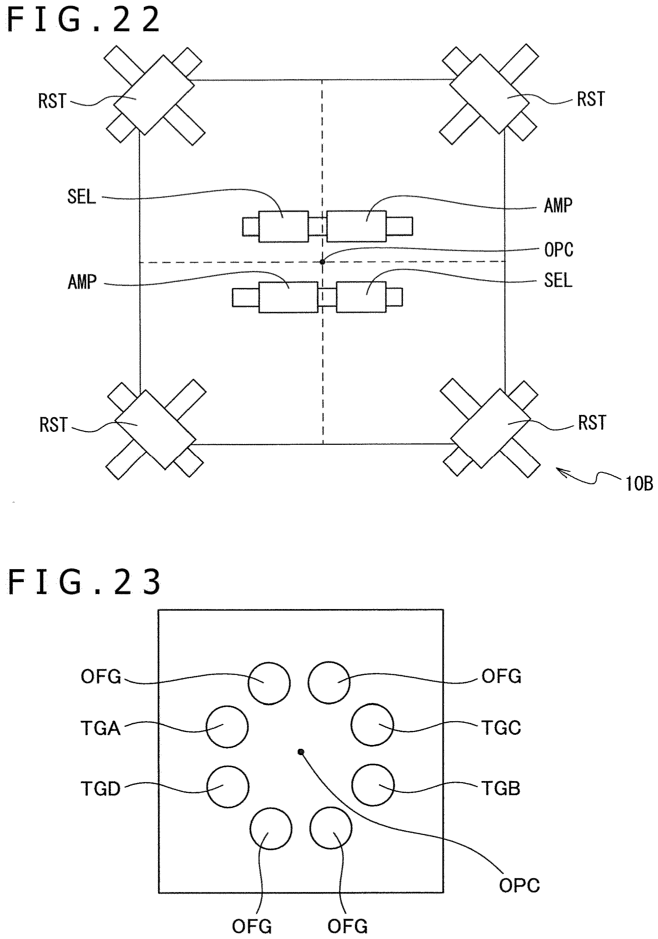

FIG. 22 is a plan view depicting a configuration of a light receiving element according to a modification example of the first embodiment.
[FIG. 23]
FIG. 23 is a plan view depicting a configuration of a light receiving element according to a modification example of the first embodiment.
[FIG. 24]

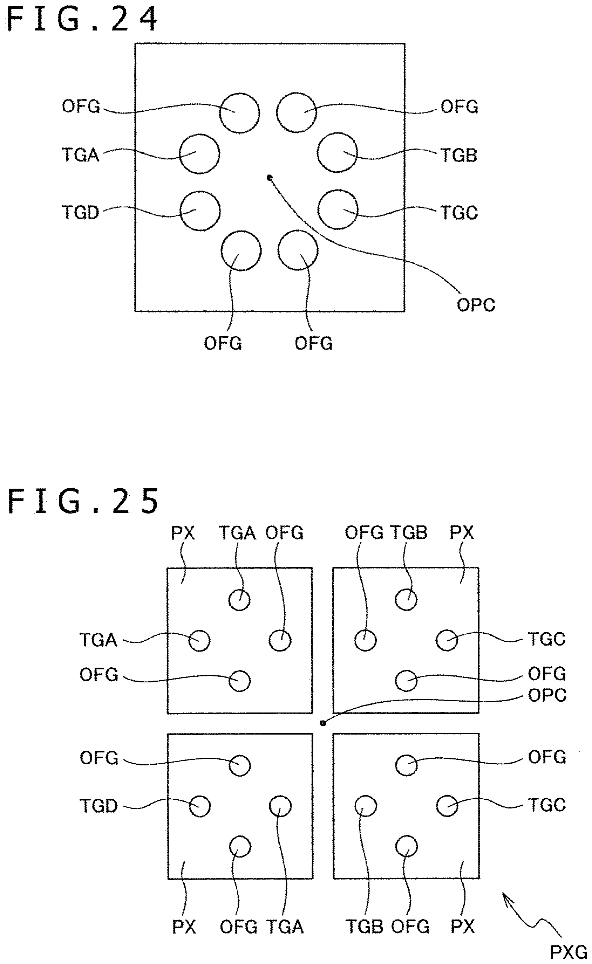

FIG. 24 is a plan view depicting a configuration of a light receiving element according to a modification example of the first embodiment.
[FIG. 25]
FIG. 25 is a plan view depicting a configuration of a light receiving element according to a modification example of the first embodiment.
[FIG. 26]

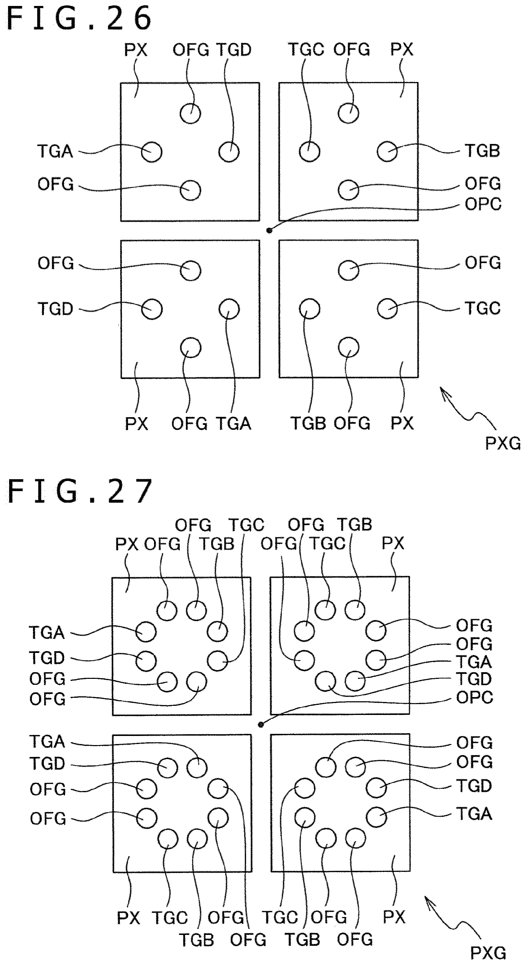

FIG. 26 is a plan view depicting a configuration of a light receiving element according to a modification example of the first embodiment.

[FIG. 27]
FIG. 27 is a plan view depicting a configuration of a light receiving element according to a modification example of the first embodiment.
[FIG. 28]

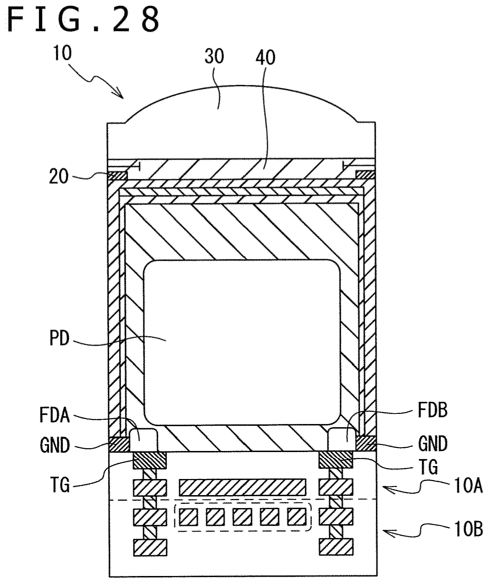

FIG. 28 is a cross-sectional view depicting a schematic configuration of a light receiving element according to a modification example of the first embodiment.
[FIG. 29]

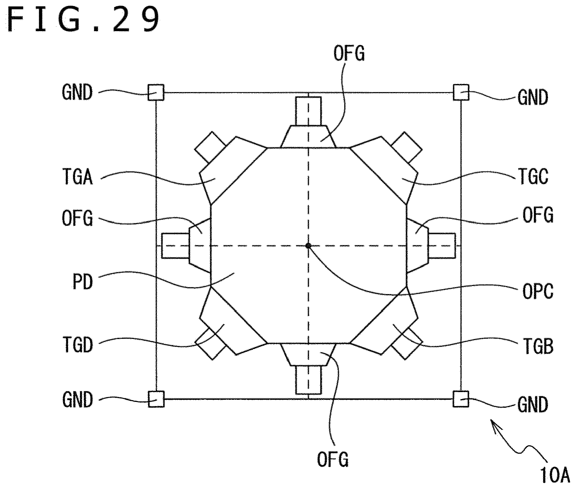

FIG. 29 is a plan view depicting a configuration of a light receiving element according to a modification example of the first embodiment.
[FIG. 30]

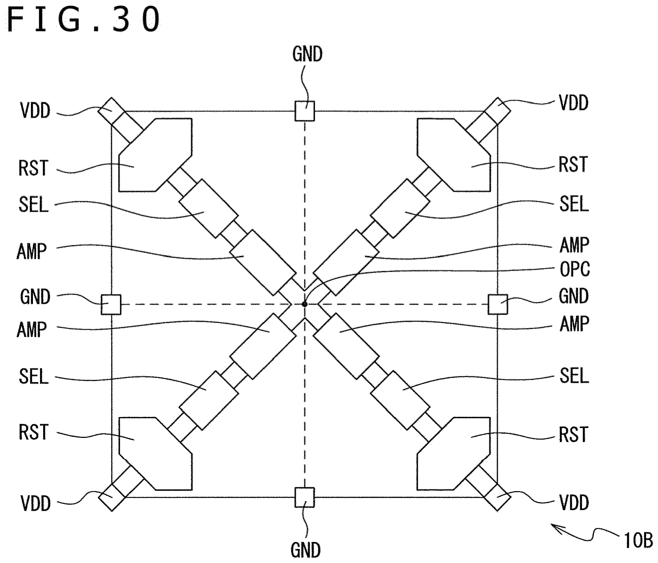

FIG. 30 is a plan view depicting a configuration of a light receiving element according to a modification example of the first embodiment.
[FIG. 31]

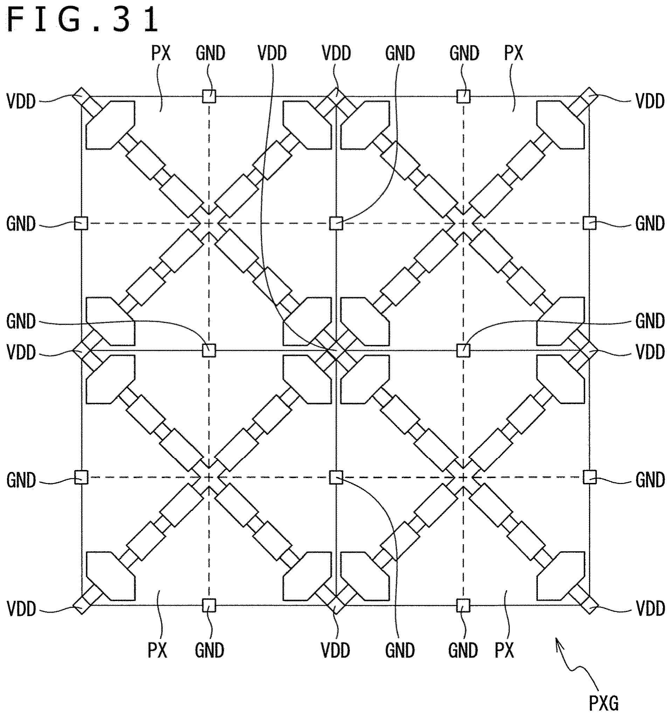

FIG. 31 is a plan view depicting a configuration of a light receiving element according to a modification example of the first embodiment.
[FIG. 32]

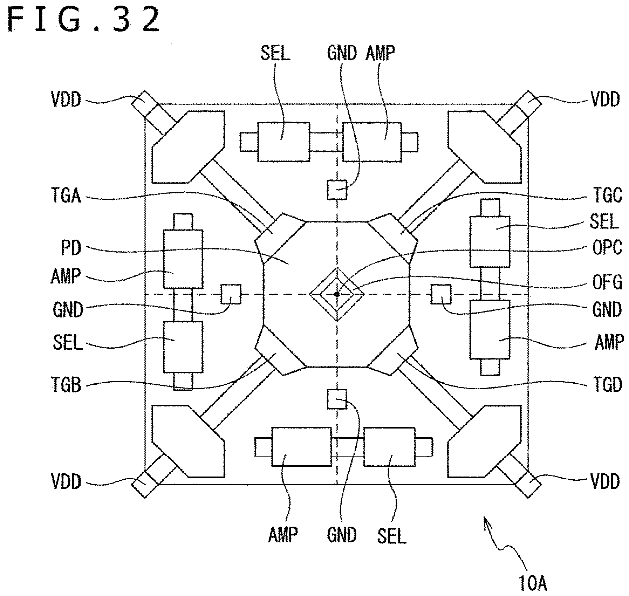

FIG. 32 is a plan view depicting a configuration of a light receiving element according to a modification example of the first embodiment.
[FIG. 33]

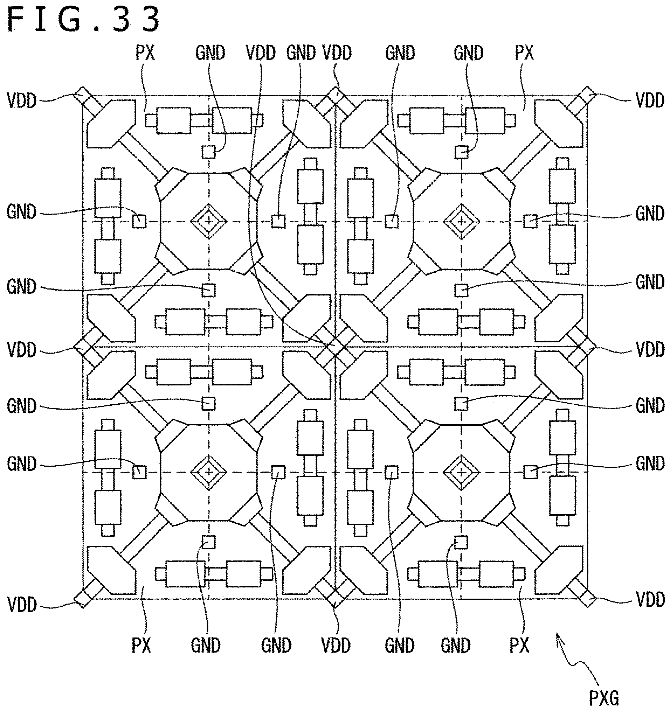

FIG. 33 is a plan view depicting a configuration of a light receiving element according to a modification example of the first embodiment.
[FIG. 34]

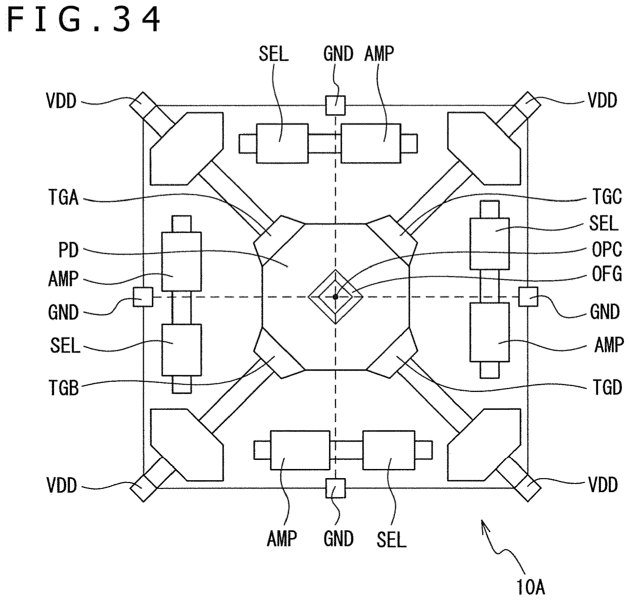

FIG. 34 is a plan view depicting a configuration of a light receiving element according to a modification example of the first embodiment.
[FIG. 35]

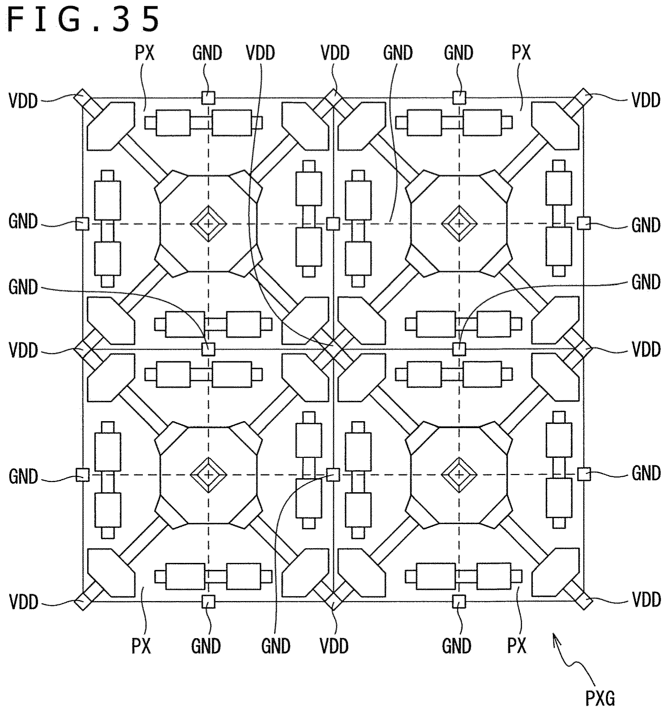

FIG. 35 is a plan view depicting a configuration of a light receiving element according to a modification example of the first embodiment.
[FIG. 36]

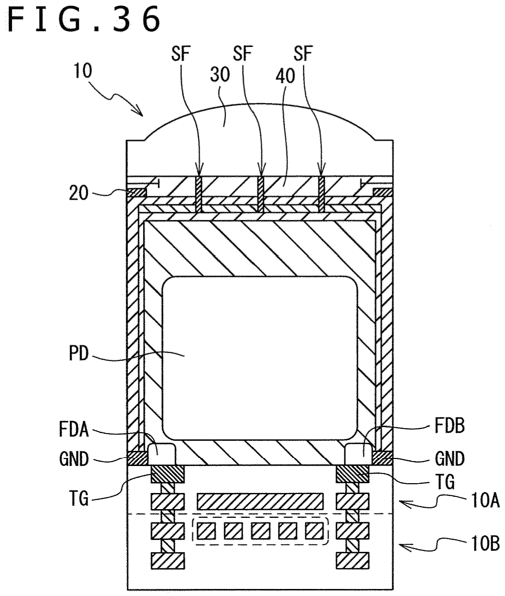

FIG. 36 is a cross-sectional view depicting a schematic configuration of a light receiving element according to a modification example of the first embodiment.
[FIG. 37]

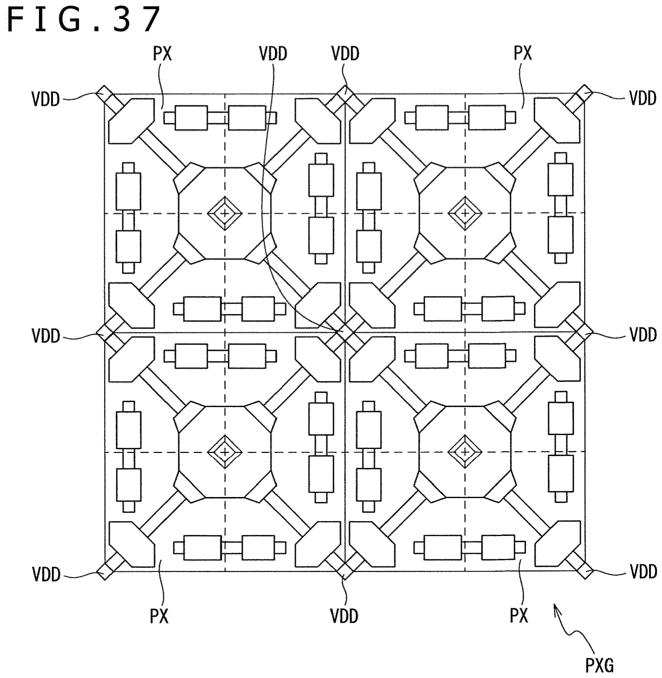

FIG. 37 is a plan view depicting a configuration of a light receiving element according to a modification example of the first embodiment.
[FIG. 38]

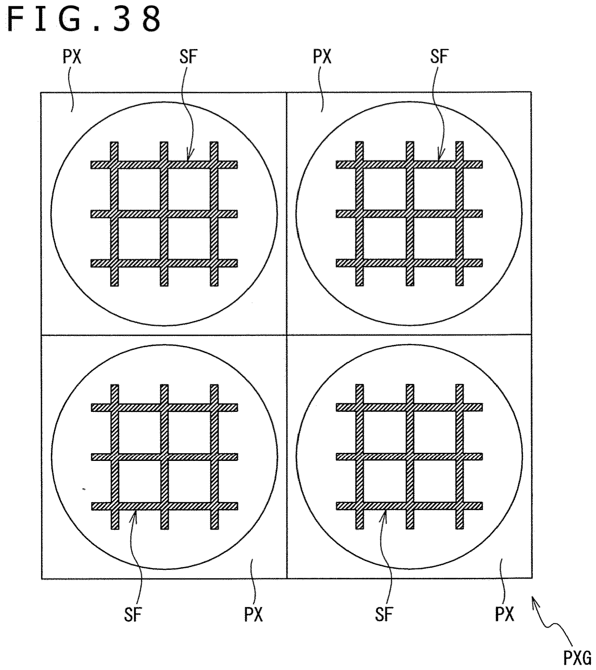

FIG. 38 is a plan view depicting a configuration of a light receiving element according to a modification example of the first embodiment.
[FIG. 39]

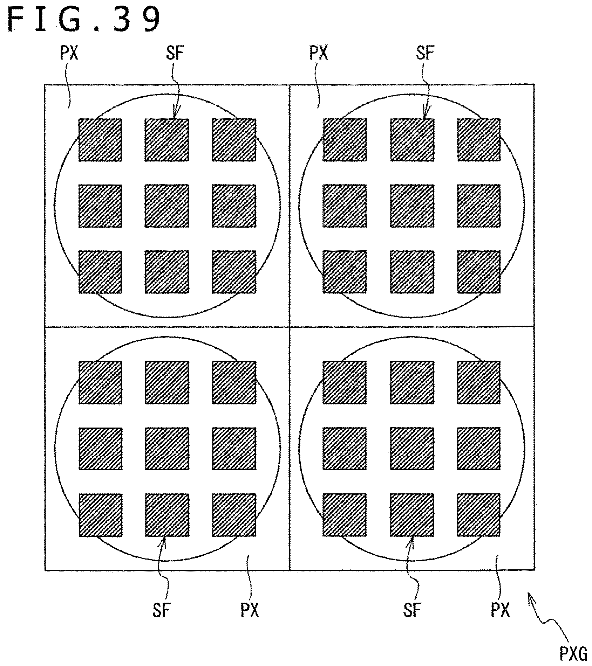

FIG. 39 is a plan view depicting a configuration of a light receiving element according to a modification example of the first embodiment.
[FIG. 40]

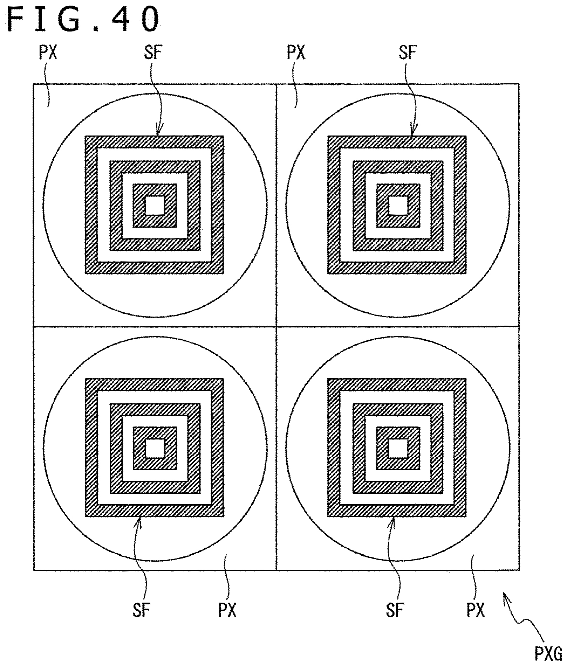

FIG. 40 is a plan view depicting a configuration of a light receiving element according to a modification example of the first embodiment.
[FIG. 41]

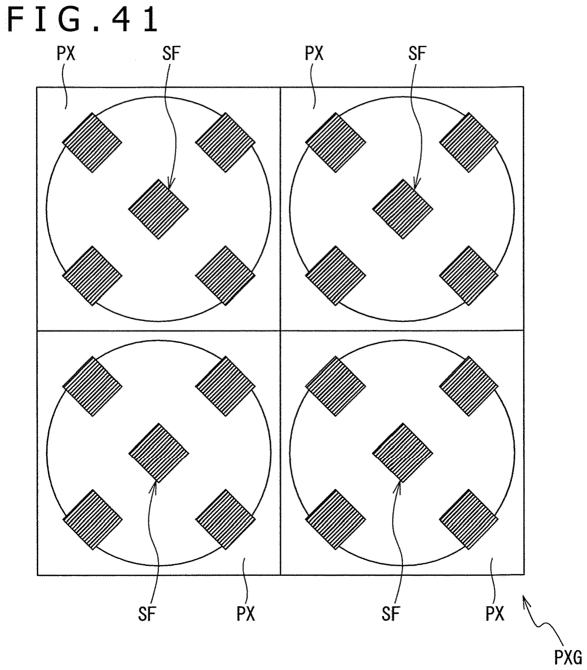

FIG. 41 is a plan view depicting a configuration of a light receiving element according to a modification example of the first embodiment.
[FIG. 42]

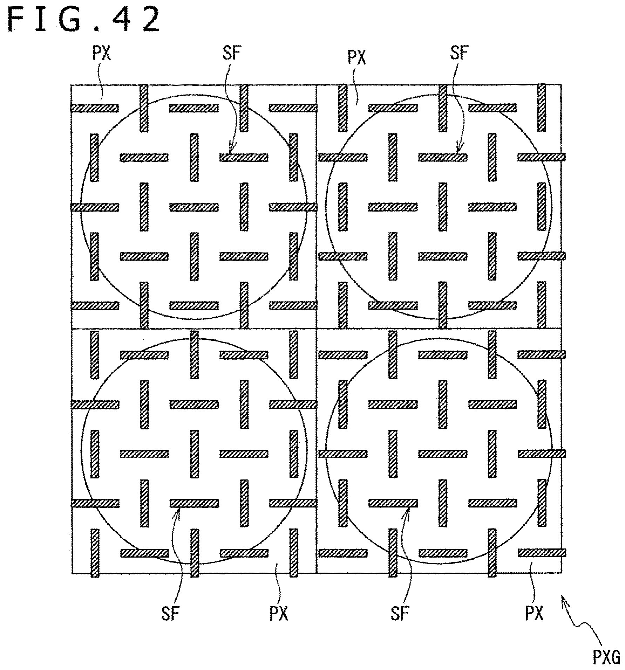

FIG. 42 is a plan view depicting a configuration of a light receiving element according to a modification example of the first embodiment.
[FIG. 43]

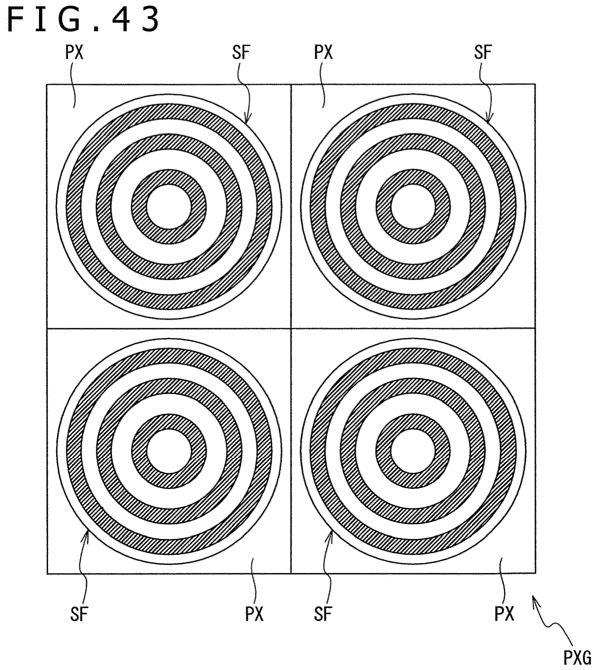

FIG. 43 is a plan view depicting a configuration of a light receiving element according to a modification example of the first embodiment.
[FIG. 44]

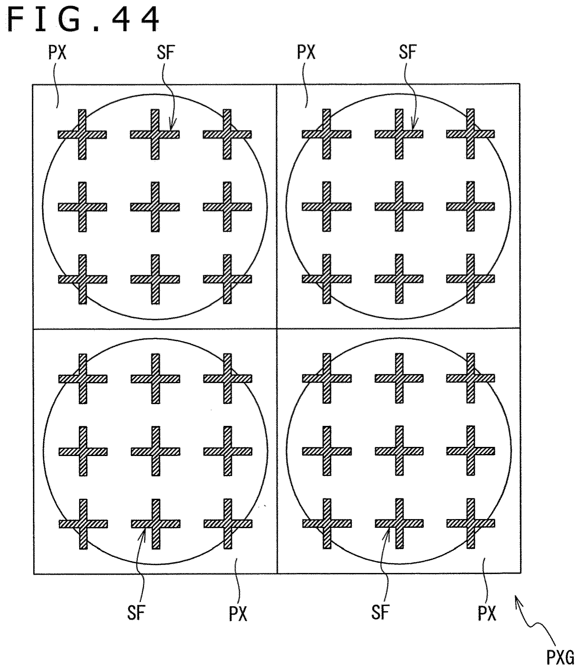

FIG. 44 is a plan view depicting a configuration of a light receiving element according to a modification example of the first embodiment.
[FIG. 45]

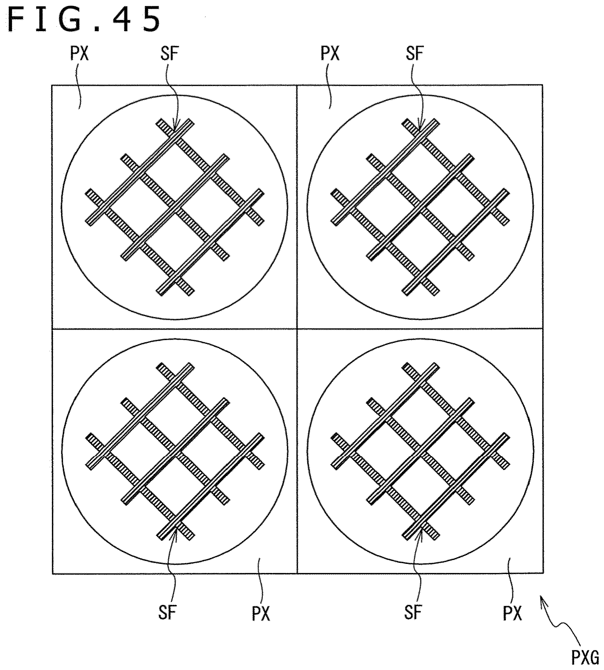

FIG. 45 is a plan view depicting a configuration of a light receiving element according to a modification example of the first embodiment.
[FIG. 46]

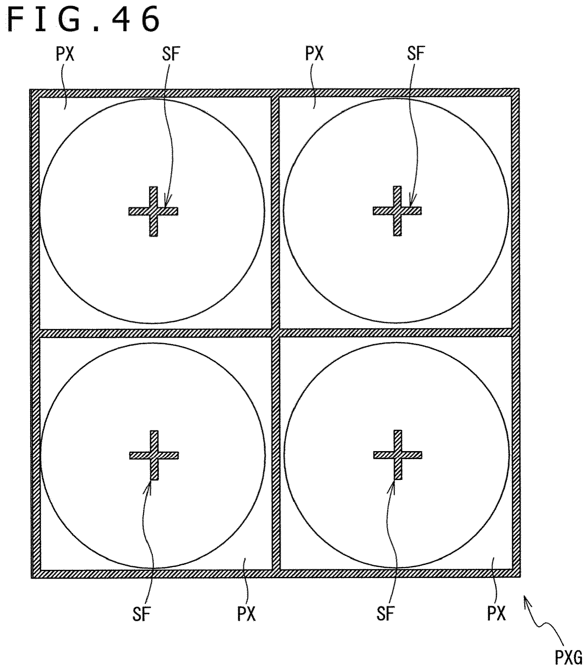

FIG. 46 is a plan view depicting a configuration of a light receiving element according to a modification example of the first embodiment.

[FIG. 47]

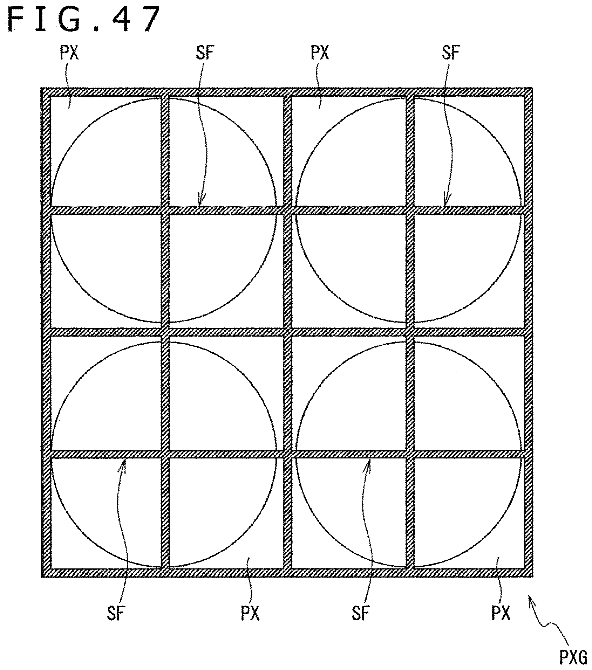

FIG. 47 is a plan view depicting a configuration of a light receiving element according to a modification example of the first embodiment.

[FIG. 48]

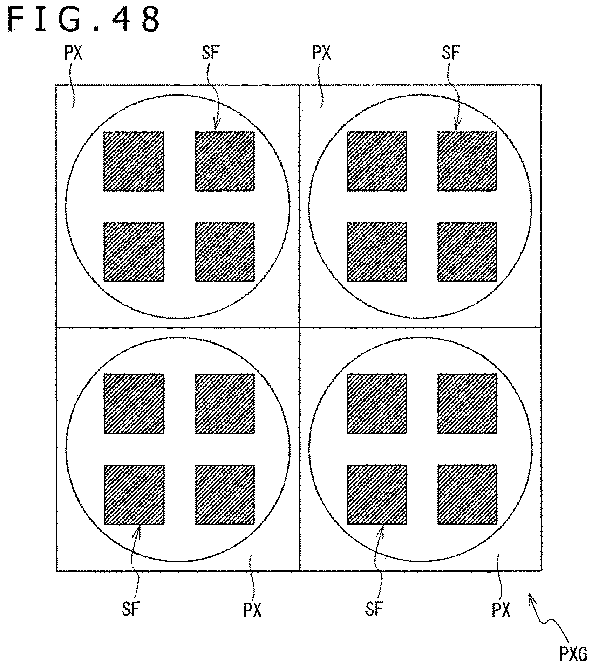

FIG. 48 is a plan view depicting a configuration of a light receiving element according to a modification example of the first embodiment.

[FIG. 49]

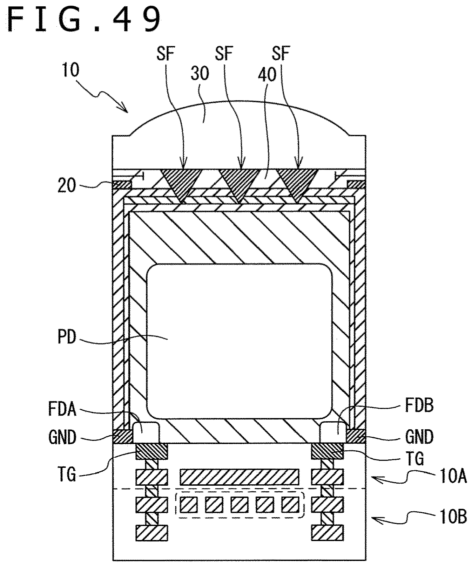

FIG. 49 is a cross-sectional view depicting a schematic configuration of a light receiving element according to a modification example of the first embodiment.

[FIG. 50]

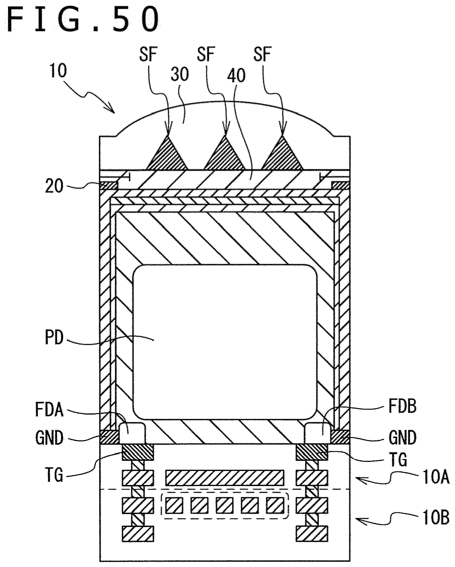

FIG. 50 is a cross-sectional view depicting a schematic configuration of a light receiving element according to a modification example of the first embodiment.

[FIG. 51]

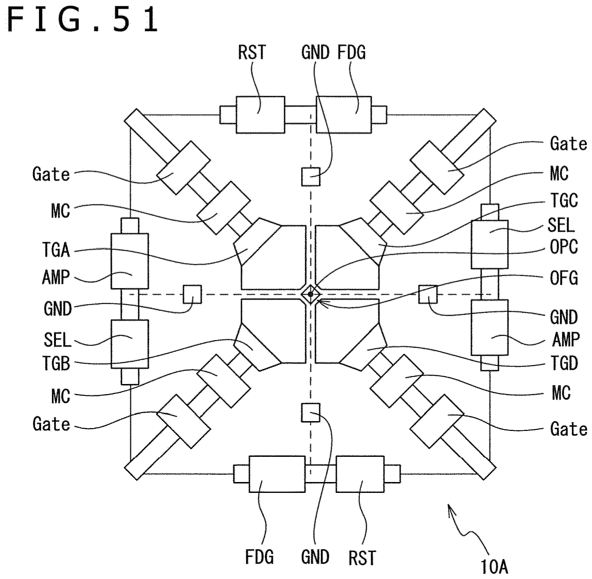

FIG. 51 is a plan view depicting a configuration of a light receiving element according to a modification example of the first embodiment.

[FIG. 52]

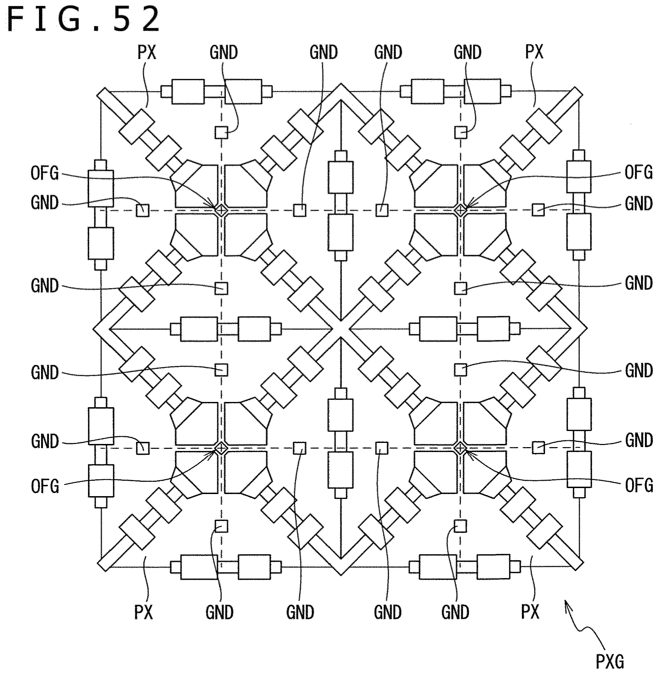

FIG. 52 is a plan view depicting a configuration of a light receiving element according to a modification example of the first embodiment.

[FIG. 53A]

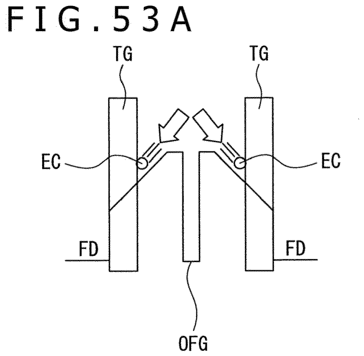

FIG. 53A is a diagram depicting a state in which transfer gates are opened in a modification example of the first embodiment.

[FIG. 53B]

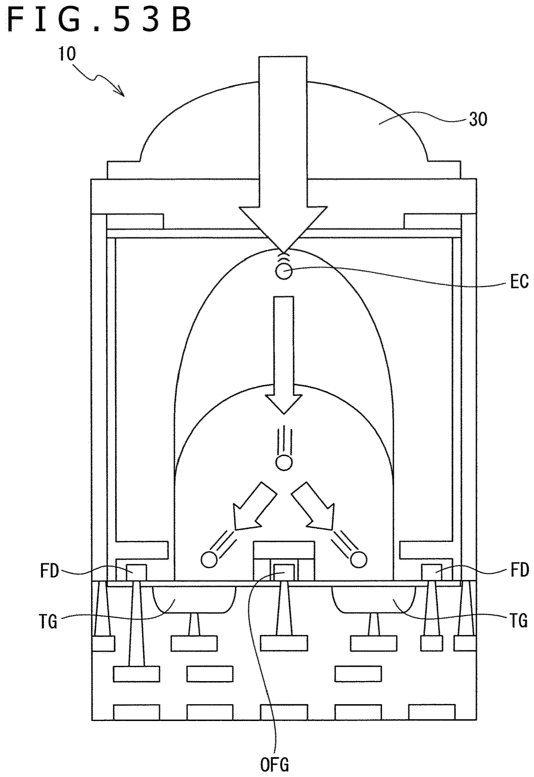

FIG. 53B is a cross-sectional view depicting movement of electric charges in the modification example of the first embodiment.

[FIG. 54A]

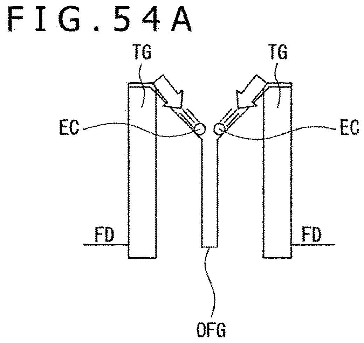

FIG. 54A is a diagram depicting a state in which the transfer gates are closed in the modification example of the first embodiment.

[FIG. 54B]

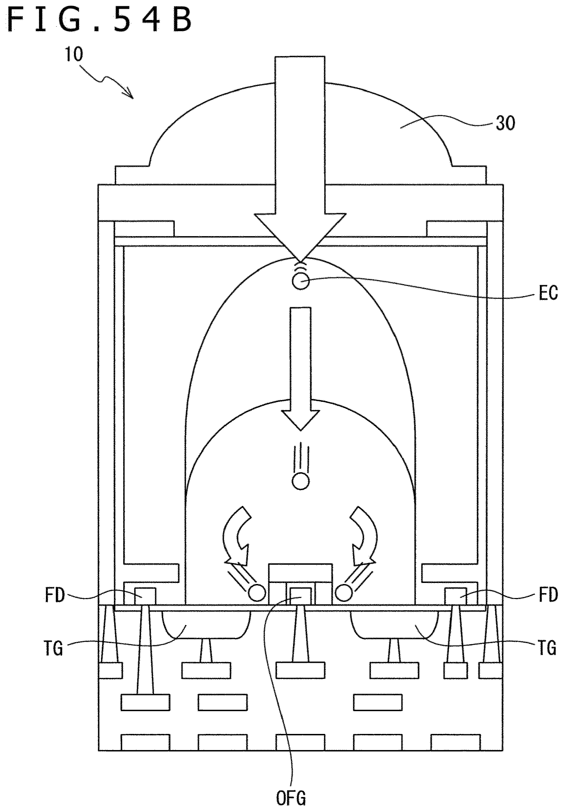

FIG. 54B is a cross-sectional view depicting the movement of electric charges in the modification example of the first embodiment.

[FIG. 55]

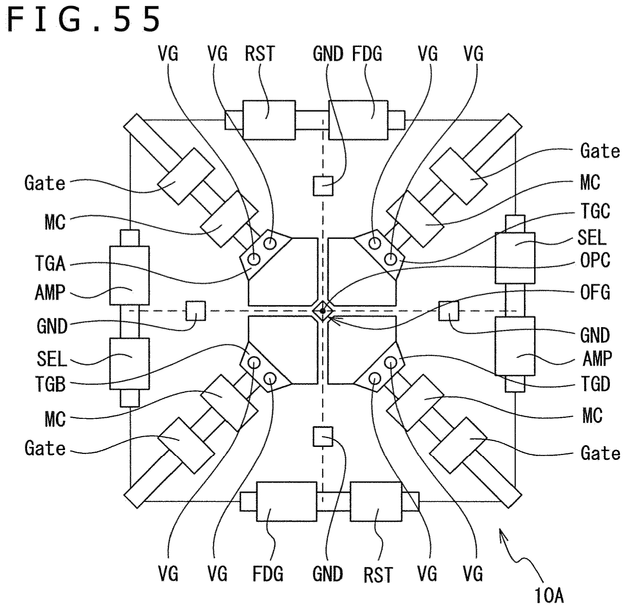

FIG. 55 is a plan view depicting a configuration of a light receiving element according to a modification example of the first embodiment.

[FIG. 56]

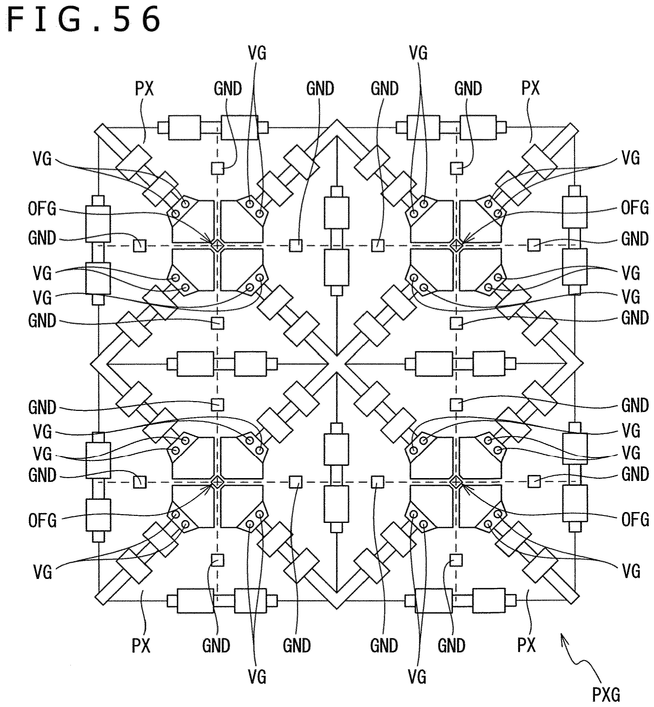

FIG. 56 is a plan view depicting a configuration of a light receiving element according to a modification example of the first embodiment.

[FIG. 57]

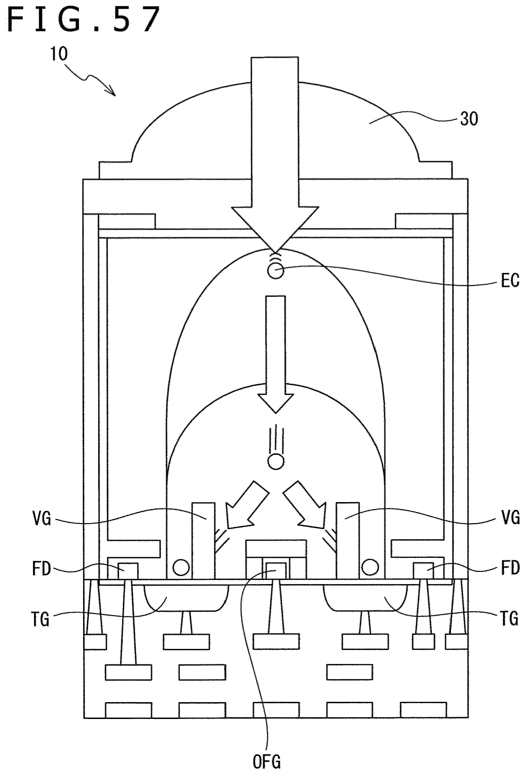

FIG. 57 is a cross-sectional view depicting the movement of electric charges in a modification example of the first embodiment.

[FIG. 58]

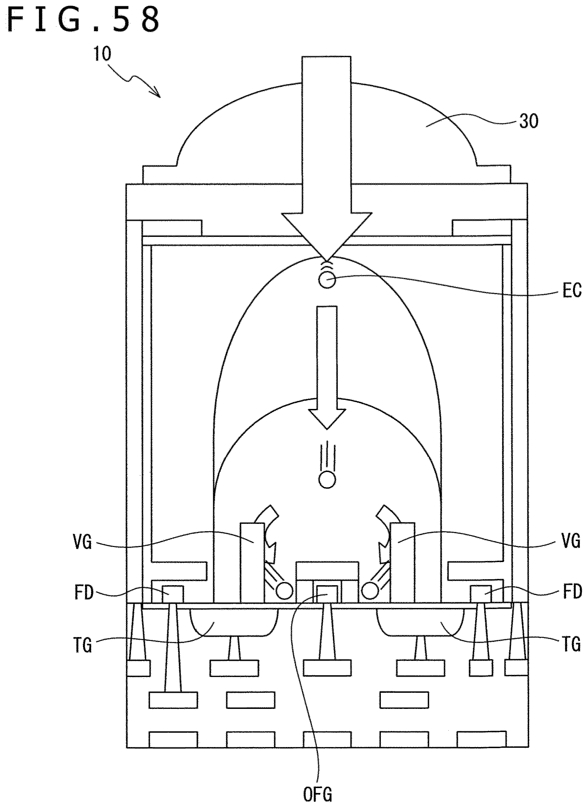

FIG. 58 is a cross-sectional view depicting the movement of electric charges in the modification example of the first embodiment.

[FIG. 59]

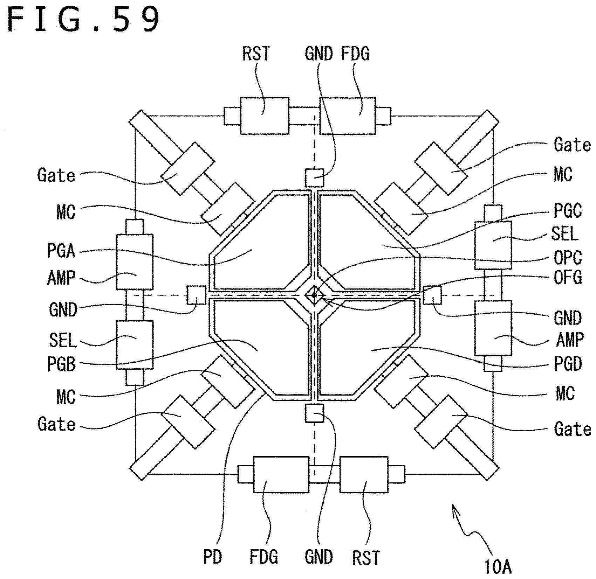

FIG. 59 is a plan view depicting a configuration of a light receiving element according to a modification example of the first embodiment.

[FIG. 60]

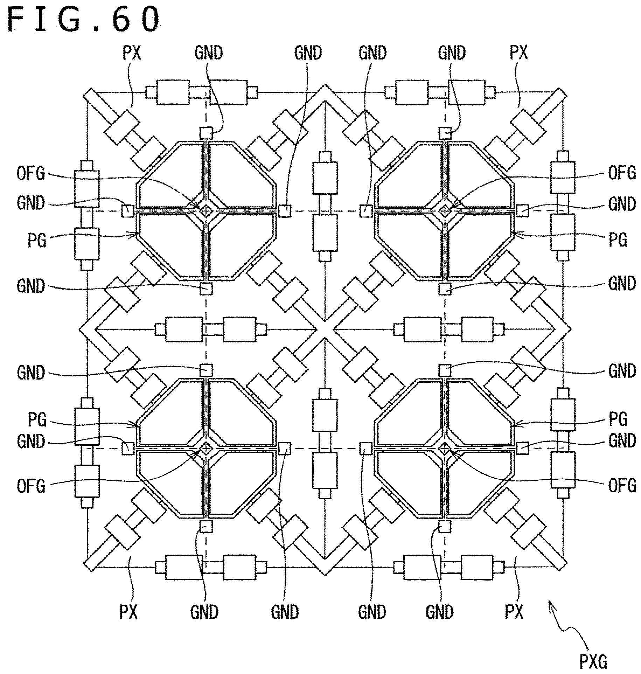

FIG. 60 is a plan view depicting a configuration of a light receiving element according to a modification example of the first embodiment.

[FIG. 61A]

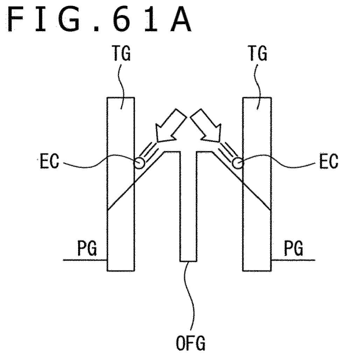

FIG. 61A is a diagram depicting a state in which the transfer gates are opened in a modification example of the first embodiment.

[FIG. 61B]

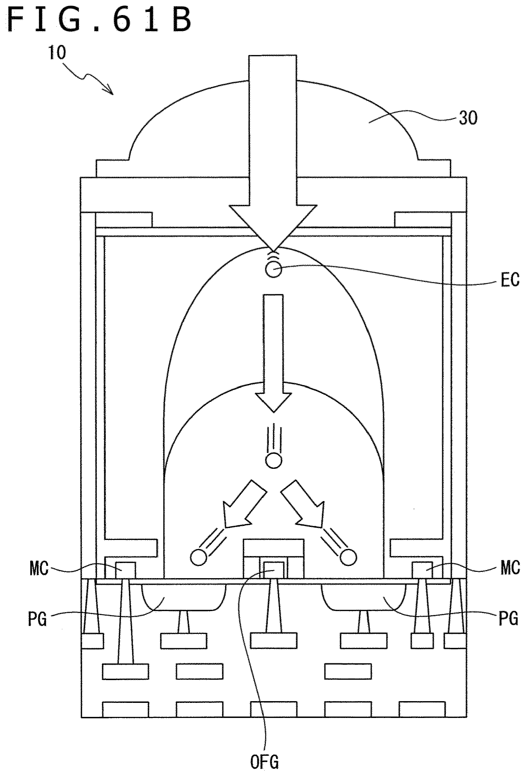

FIG. 61B is a cross-sectional view depicting the movement of electric charges in the modification example of the first embodiment.

[FIG. 62A]

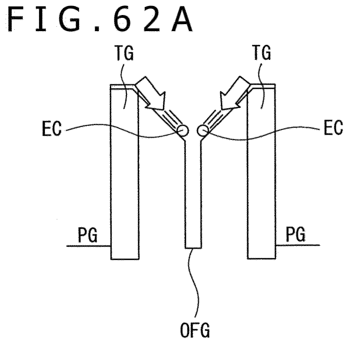

FIG. 62A is a diagram depicting a state in which the transfer gates are closed in the modification example of the first embodiment.

[FIG. 62B]

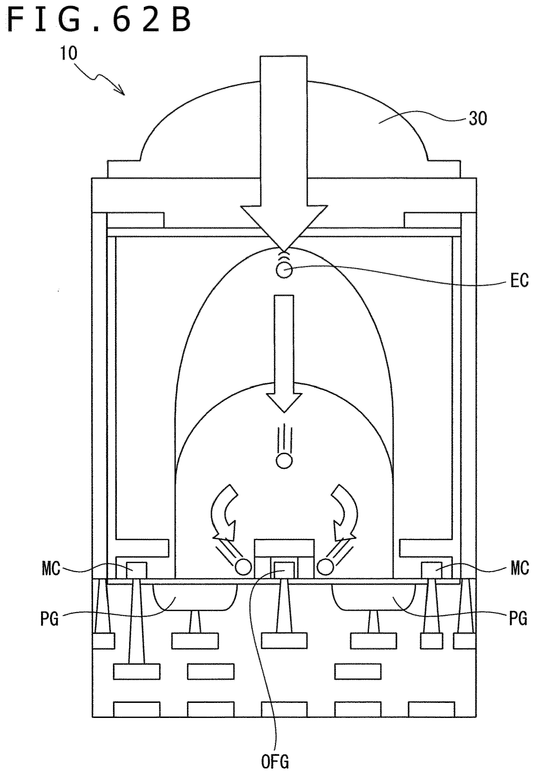

FIG. 62B is a cross-sectional view depicting the movement of electric charges in the modification example of the first embodiment.

[FIG. 63]

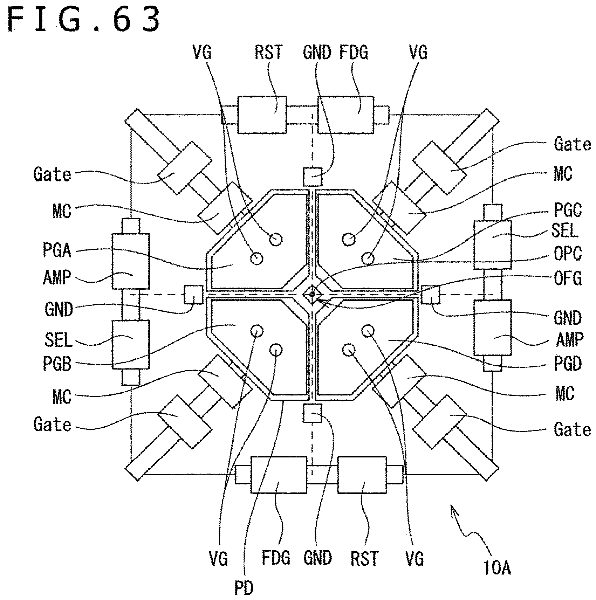

FIG. 63 is a plan view depicting a configuration of a light receiving element according to a modification example of the first embodiment.

[FIG. 64]

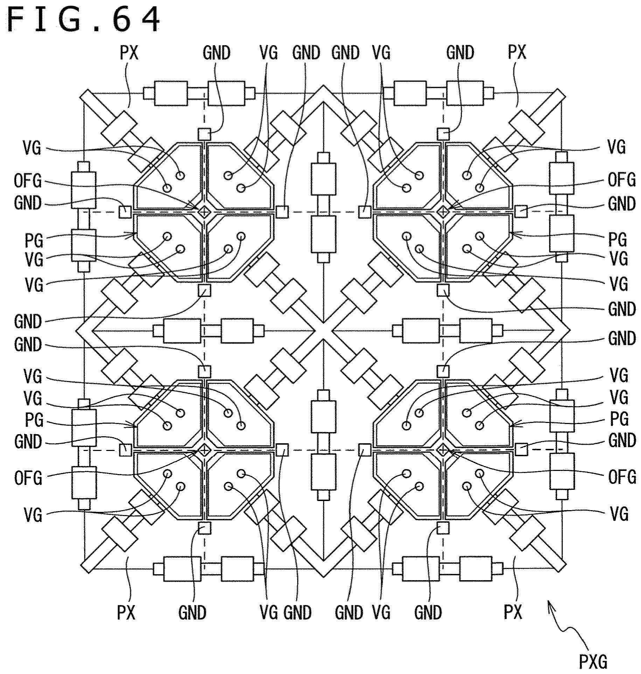

FIG. 64 is a plan view depicting a configuration of a light receiving element according to a modification example of the first embodiment.

[FIG. 65]

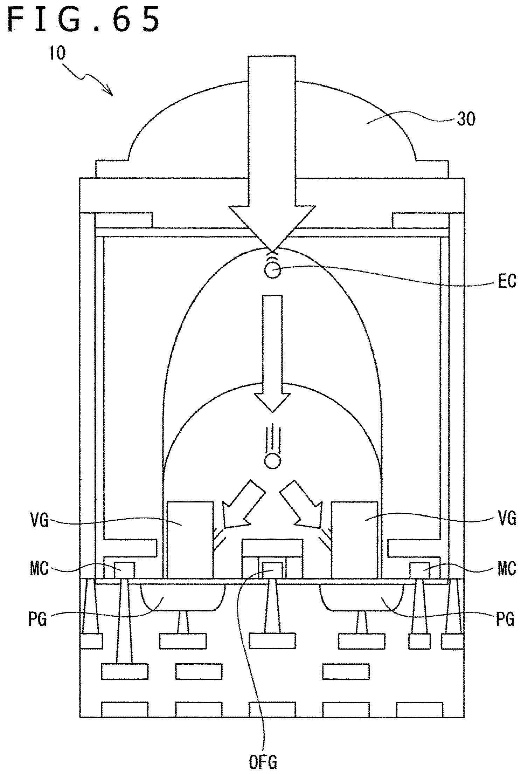

FIG. 65 is a cross-sectional view depicting the movement of electric charges in a modification example of the first embodiment.

[FIG. 66]

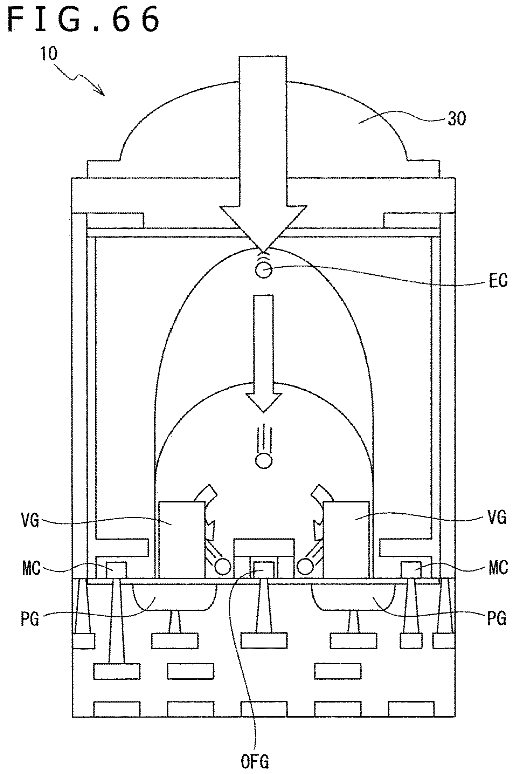

FIG. 66 is a cross-sectional view depicting the movement of electric charges in the modification example of the first embodiment.

[FIG. 67]

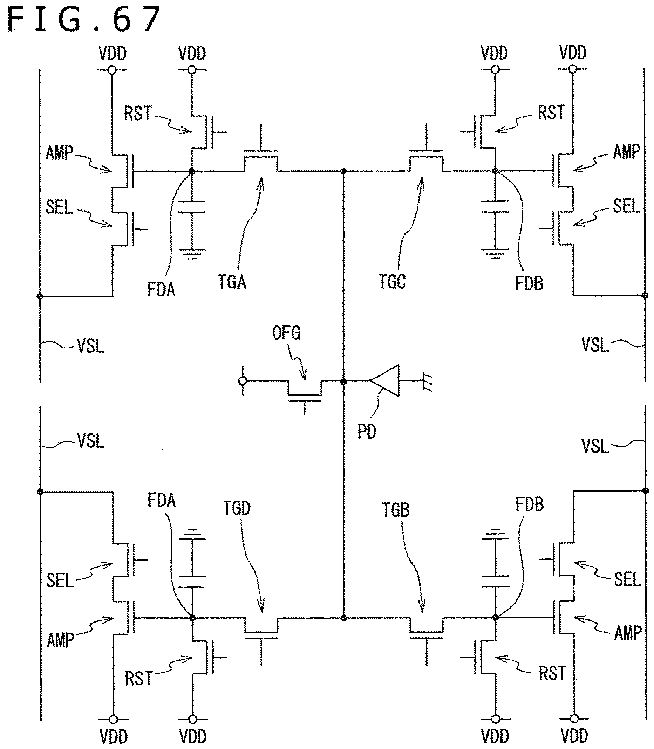

FIG. 67 is a diagram depicting a circuit configuration of a light receiving element in a modification example of the first embodiment.

[FIG. 68]

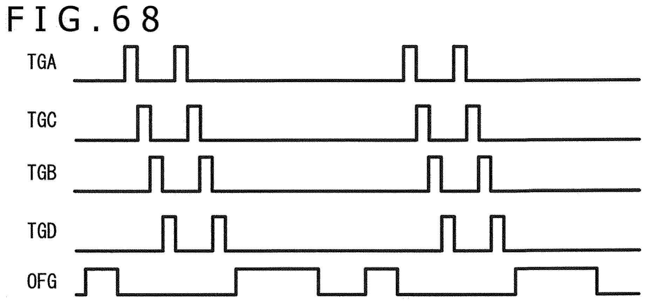

FIG. 68 is a timing chart depicting the operations of transfer gates and an overflow gate in a modification example of the first embodiment.

[FIG. 69]

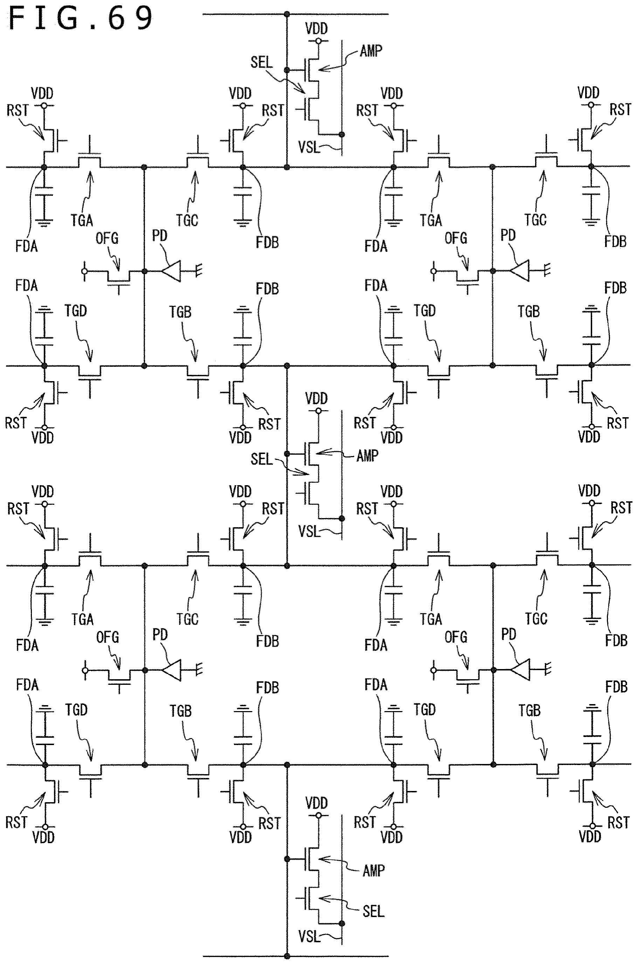

FIG. 69 is a diagram depicting a circuit configuration of a light receiving element in a modification example of the first embodiment.

[FIG. 70]

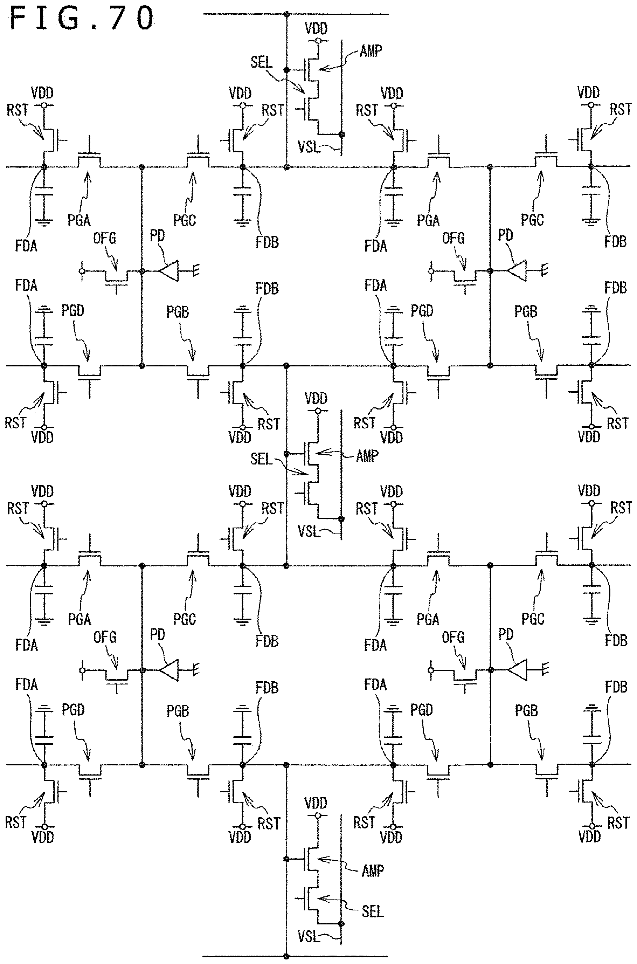

FIG. 70 is a diagram depicting a circuit configuration of a light receiving element in a modification example of the first embodiment.

[FIG. 71]

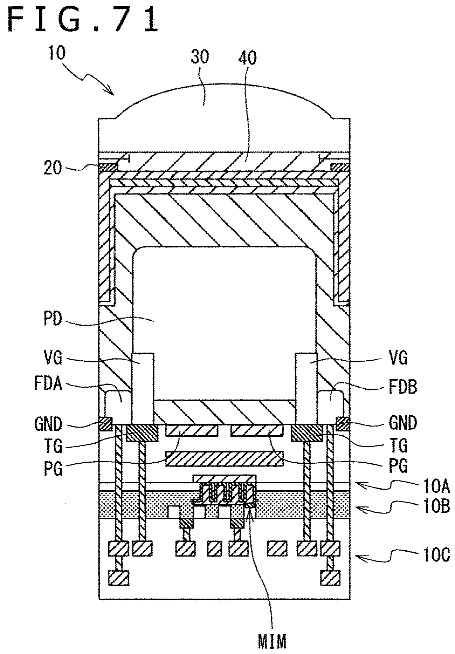

FIG. 71 is a cross-sectional view depicting a schematic configuration of a light receiving element according to a modification example of the first embodiment.

[FIG. 72]

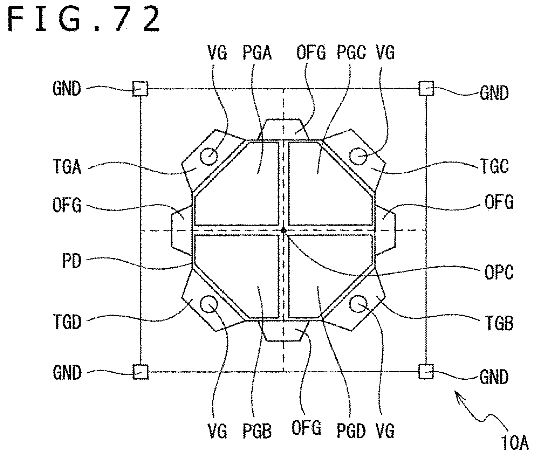

FIG. 72 is a plan view depicting a configuration of a light receiving element according to a modification example of the first embodiment.

[FIG. 73]

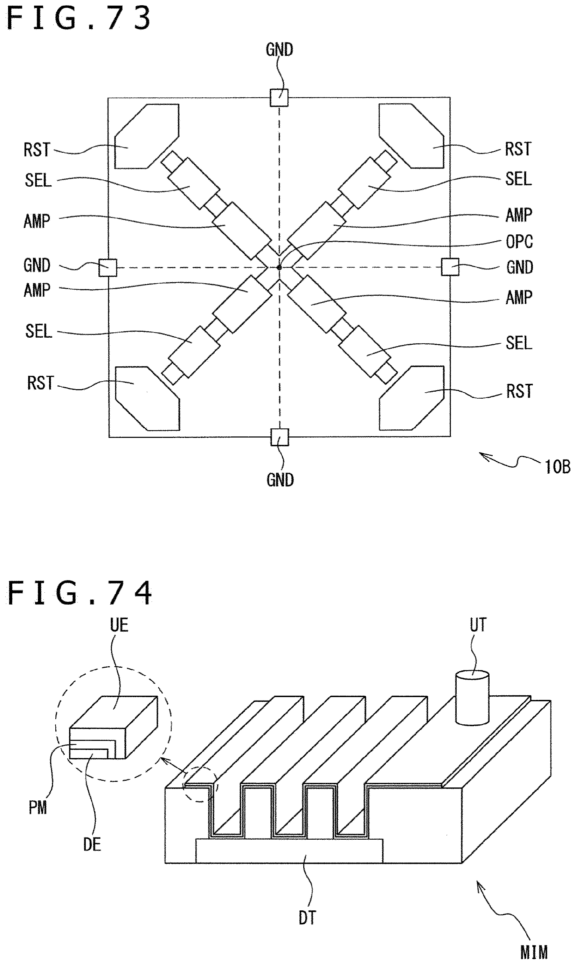

FIG. 73 is a plan view depicting a configuration of a light receiving element according to a modification example of the first embodiment.

[FIG. 74]

FIG. 74 is a cross-sectional view depicting a configuration of a capacitor in a modification example of the first embodiment.

[FIG. 75]

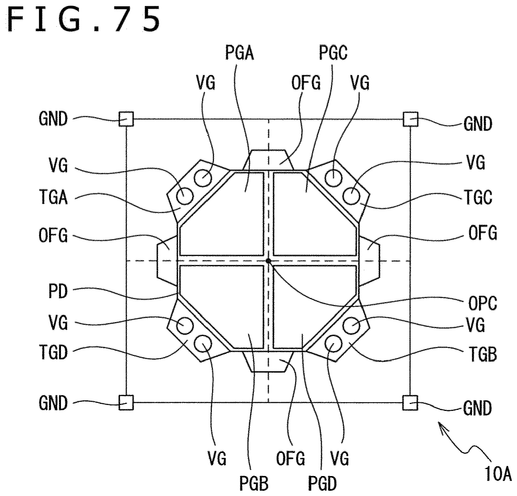

FIG. 75 is a plan view depicting a configuration of a light receiving element according to a modification example of the first embodiment.

[FIG. 76]

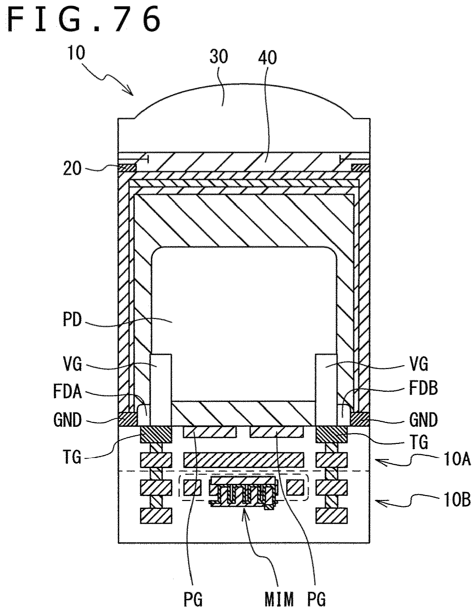

FIG. 76 is a cross-sectional view depicting a schematic configuration of a light receiving element according to a modification example of the first embodiment.

[FIG. 77]

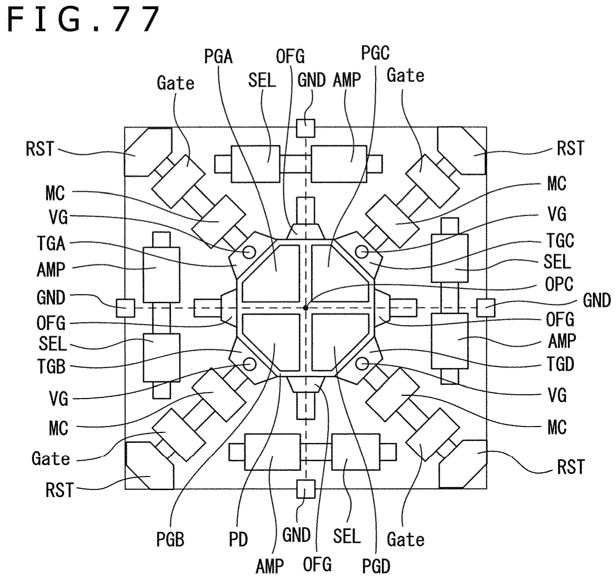

FIG. 77 is a plan view depicting a configuration of a light receiving element according to a modification example of the first embodiment.

[FIG. 78]

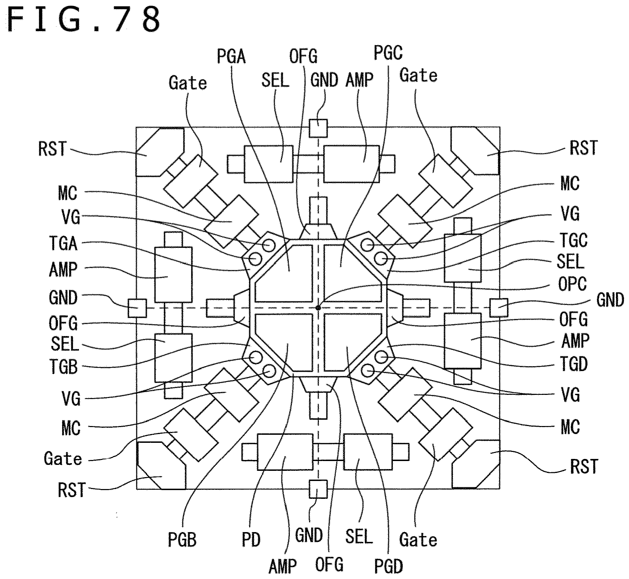

FIG. 78 is a plan view depicting a configuration of a light receiving element according to a modification example of the first embodiment.

[FIG. 79]

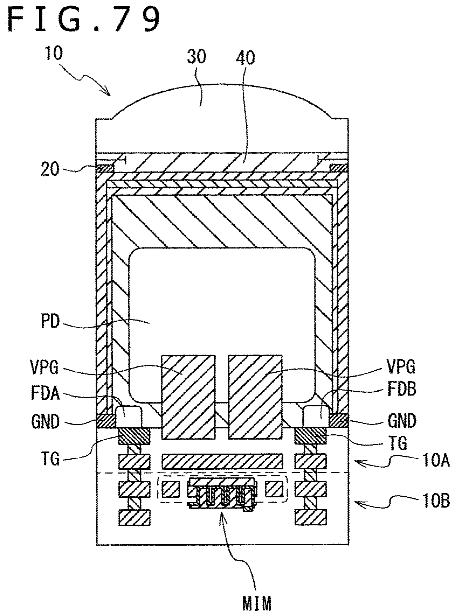

FIG. 79 is a cross-sectional view depicting a schematic configuration of a light receiving element according to a modification example of the first embodiment.

[FIG. 80]

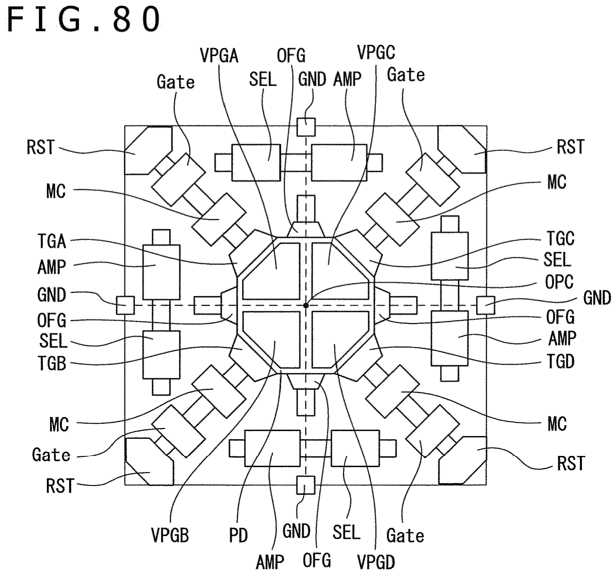

FIG. 80 is a plan view depicting a configuration of a light receiving element according to a modification example of the first embodiment.

[FIG. 81]

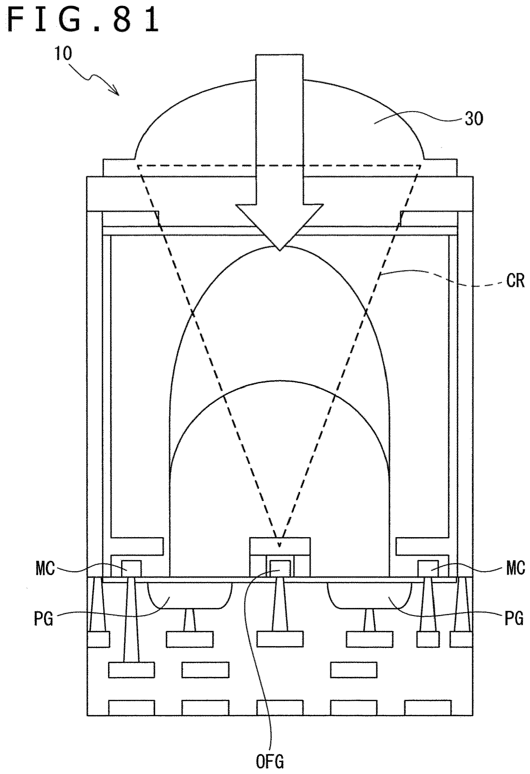

FIG. 81 is a cross-sectional view depicting a schematic configuration of a light receiving element according to a modification example of the first embodiment.
[FIG. 82]

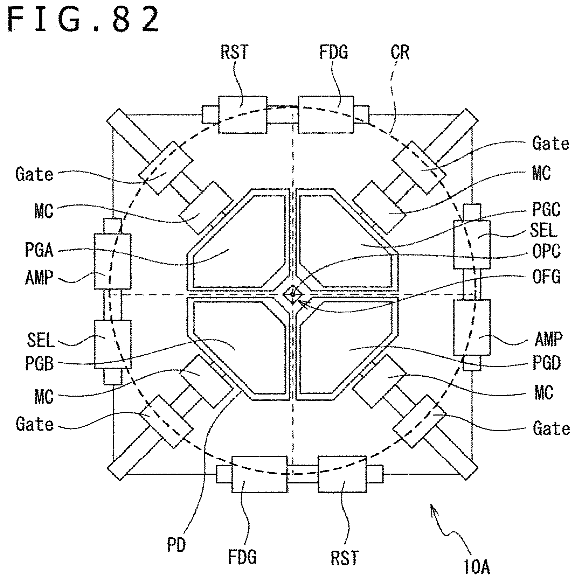

FIG. 82 is a plan view depicting a configuration of a light receiving element according to a modification example of the first embodiment.
[FIG. 83]

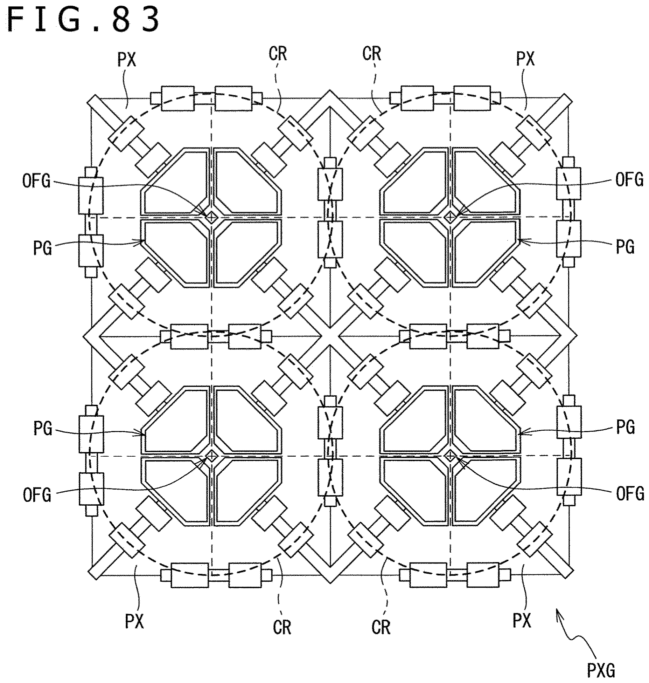

FIG. 83 is a plan view depicting a configuration of a light receiving element according to a modification example of the first embodiment.
[FIG. 84]

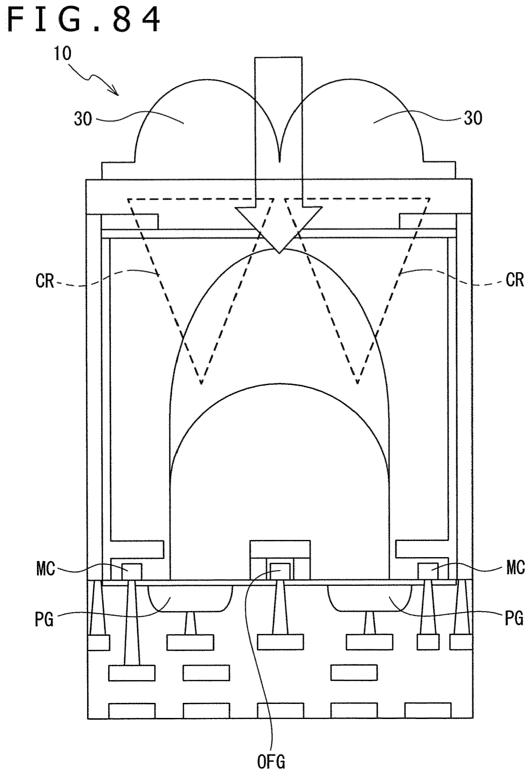

FIG. 84 is a cross-sectional view depicting a schematic configuration of a light receiving element according to a modification example of the first embodiment.
[FIG. 85]

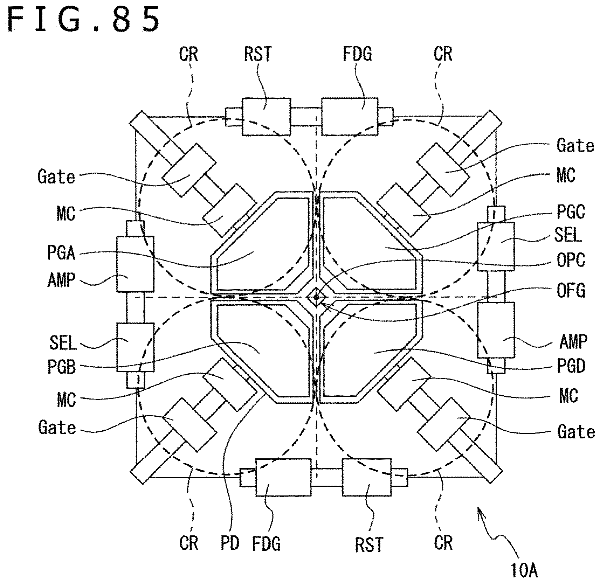

FIG. 85 is a plan view depicting a configuration of a light receiving element according to a modification example of the first embodiment.
[FIG. 86]

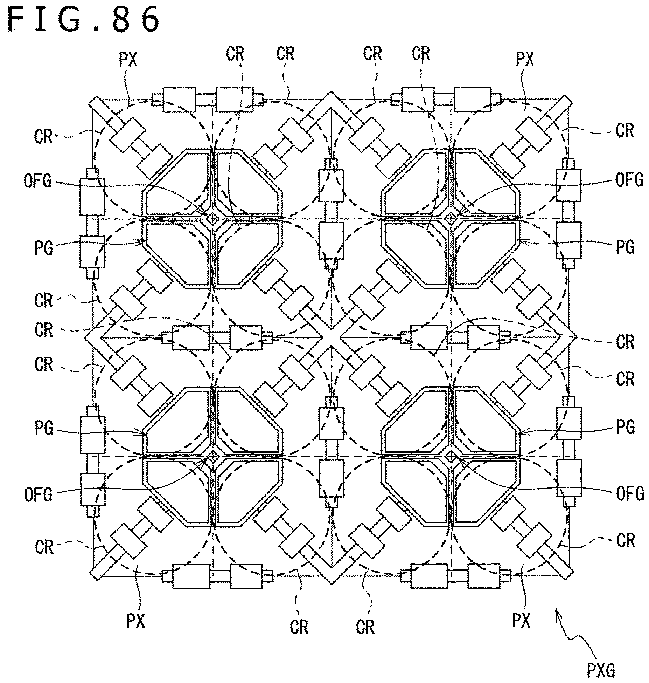

FIG. 86 is a plan view depicting a configuration of a light receiving element according to a modification example of the first embodiment.
[FIG. 87]

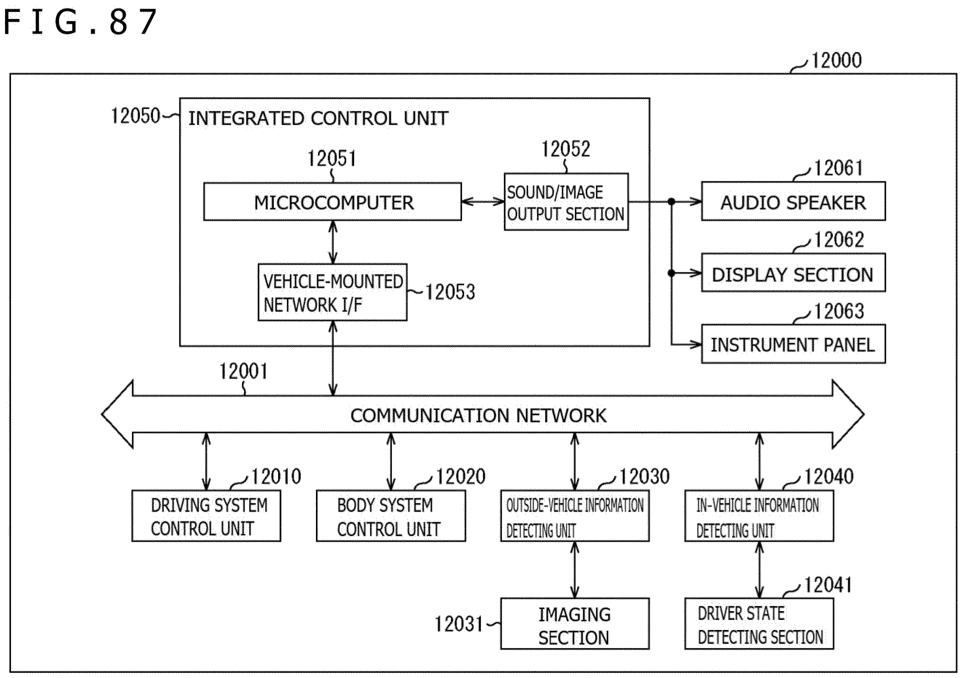

FIG. 87 is a block diagram depicting an example of schematic configuration of a vehicle control system.
[FIG. 88]

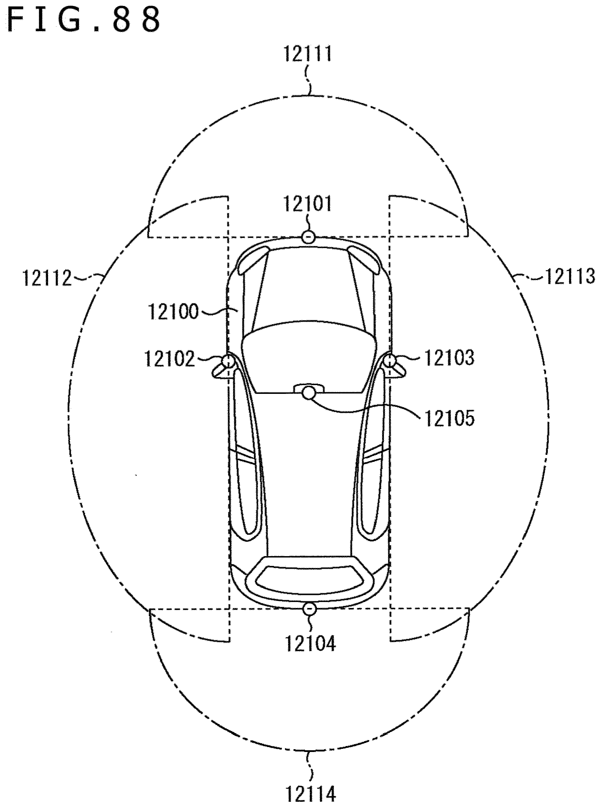

FIG. 88 is a diagram of assistance in explaining an example of installation positions of an outside-vehicle information detecting section and an imaging section.

[Description of Embodiments]

Hereinafter, embodiments of the present technology will be described with reference to the drawings. In the description of the drawings, the same or similar parts are designated by the same or similar reference signs, and duplicate description will be omitted. Each drawing is schematic and may differ from the actual one. The embodiments depicted below exemplify devices and methods for embodying the technical idea of the present technology, and the technical idea of the present technology does not specify the devices and methods exemplified in the following embodiments. The technical idea of the present technology can be modified in various ways within the technical scope described in the claims.

(First Embodiment)

<Ranging module>

As depicted in FIG. 1, a ranging module 1 according to the first embodiment includes a light emitting unit 2, a light emission control unit 4, and a light receiving element 10.

The ranging module 1 is a device for irradiating an object whose distance is to be measured with light emitted from the light emitting unit 2, and measuring the distance to the object by using light reflected by the object and incident on the light receiving element 10.

<Light emitting unit>

The light emitting unit 2 has a light source that emits light set to a predetermined wavelength, and emits irradiation light whose brightness fluctuates periodically to irradiate an object. The light source includes, for example, a light emitting diode that emits infrared light having a wavelength set in the range of 780 [nm] to 1000 [nm] inclusive. Further, the light emitting unit 2 generates irradiation light in synchronization with a light emission control signal CKp forming a rectangular wave supplied from the light emission control unit 4.

<Light emission control unit>

The light emission control unit 4 controls an irradiation timing of the irradiation light by supplying the light emission control signal CLKp to the light emitting unit 2 and the light receiving element 10. A frequency of the light emission control signal CLKp is 20 [MHz], for example. Note that the frequency of the light emission control signal CLKp is not limited to 20 [MHz], and may be 5 [MHz] or the like. Further, the light emission control signal CLKp is not limited to a rectangular wave shape as long as it is a periodic signal. For example, the light emission control signal CLKp may form a sine wave.

<Light receiving element>

The light receiving element 10 receives the reflected light reflected by the object, and calculates distance information for each pixel according to the light receiving result, thereby generating a depth image representing the distance to the object by a grey scale value for each pixel to output the image. Further, the light receiving element 10 is formed by using a gate type indirect ToF sensor of a back-illuminated type, for example.

Further, the light receiving element 10 calculates distance information for each pixel from a signal intensity detected by one pixel formed by arranging plural unit pixels, on the basis of the light emission control signal CLKp, for example.

Further, as depicted in FIGS. 2 to 4, the light receiving element 10 includes a first semiconductor layer 10A, a second semiconductor layer 10B, and a light-shielding film 20. Note that FIGS. 2 to 4 depict a configuration of the light receiving element 10 corresponding to one pixel formed by arranging plural (four) unit pixels.

<First semiconductor layer>

The first semiconductor layer 10A is a substrate on which a pixel circuit including a photodiode PD and plural floating diffusions FD is arranged. Further, the first semiconductor layer 10A has plural transfer gates TG and plural overflow gates OFG.

<Second semiconductor layer>

The second semiconductor layer 10B is a substrate stacked on a surface of the first semiconductor layer 10A opposite to the surface on which the photodiode PD is arranged (lower surface in FIG. 2). Further, the second semiconductor layer 10B has plural reset transistors RST, plural amplification transistors AMP, and plural selection transistors SEL. Incidentally, in FIG. 2, a direction in which the first semiconductor layer 10A and the second semiconductor layer 10B are stacked is referred to as a "stacking direction."

<Light-shielding film>

The light-shielding film 20 is arranged at a position closer to the position where the light is incident on the light receiving element 10 than the photodiode PD is. Further, the light-shielding film 20 is a film that performs shielding in such a manner that the range of light incident on the photodiode PD is a preset range. Incidentally, the light incident on the light receiving element 10 is transmitted through an on-chip lens 30 and an antireflection layer 40 and incident on the light-shielding film 20.

<On-chip lens>

The on-chip lens 30 is a lens having a function of condensing light toward the photodiode PD. Further, the on-chip lens 30 is arranged on the side of the light receiving element 10 on which the light to the photodiode PD is incident. As a material of the on-chip lens 30, an organic material or a silicon oxide film ($SiO_2$), for example, can be used.

<Photodiode>

The photodiode PD photoelectrically converts the incident light that has passed through the range set by the light-shielding film 20, and generates and accumulates electric charge according to the amount of light of the photoelectric conversion. Further, as depicted in FIG. 5, the photodiode PD is connected to transfer gates TG and an overflow gate OFG.

Further, the photodiode PD is formed by using Si, Ge, or the like in a separation region formed by using P-type ions or the like. Still further, an active region (depletion layer) is formed on the photodiode PD by applying a gate potential.

<Floating diffusion>

As depicted in FIG. 5, the floating diffusion FD is formed at a point (connection point) connecting the transfer gate TG to a selection transistor SEL and an amplification transistor AMP.

In the first embodiment, a case where two floating diffusions FD (first floating diffusion FDA and second floating diffusion FDB) are formed will be described.

Further, the floating diffusion FD accumulates electric charge transferred from the photodiode PD via the transfer gate TG and converts the charge into a voltage. That is, signal charge accumulated in the photodiode PD is transferred to the floating diffusion FD.

<Transfer gate>

As depicted in FIG. 5, the plural transfer gates TG are each connected to a photodiode PD and a floating diffusion FD. Further, the transfer gate TG is formed by using polysilicon, for example.
In the first embodiment, as an example, a case where the number of the transfer gates TG is four will be described as depicted in FIG. 4.
Further, each transfer gate TG distributes and transfers the signal charge accumulated in the photodiode PD to plural floating diffusions FD according to drive signals supplied from a timing control unit (not depicted).
In the first embodiment, as depicted in FIG. 4, a case where the transfer gates TG that transfer the signal charge to the first floating diffusion FDA include two transfer gates TG (transfer gate TGA, transfer gate TGB) will be described. Similarly, a case where the transfer gates TG that transfer the signal charge to the second floating diffusion FDB include two transfer gates TG (transfer gate TGC and transfer gate TGD) will be described.
That is, in the first embodiment, at least two of the plural transfer gates TG transfer the signal charge accumulated in the photodiode PD to one floating diffusion FD.
Further, the plural transfer gates TG are arranged point-symmetrically with respect to an optical center OPC as depicted in FIG. 4 when viewed from the incident direction of the light incident on the light receiving element 10.
In the first embodiment, a case where the optical center OPC is set to one pixel formed by arranging plural unit pixels will be described.
Note that the optical center OPC is, for example, the center of the photodiode PD as seen from the incident direction of light. However, the present invention is not limited to this, and the optical center OPC may be set as the center of the on-chip lens 30, for example, as viewed from the incident direction of light.
Further, the four transfer gates TG are arranged at positions forming vertices of a quadrangle with respect to the optical center OPC as depicted in FIG. 4 when viewed from the incident direction of the light incident on the light receiving element 10. That is, the four transfer gates TG are arranged on two virtual straight lines perpendicular to each other with the optical center OPC as their intersection.

<Overflow gate>

Each of the plural overflow gates OFG discharges charge overflowing from the floating diffusion FD according to the drive signal supplied from the timing control unit (not depicted). Further, the overflow gate OFG is formed by using polysilicon, for example.
In the first embodiment, as an example, a case where the number of overflow gates OFG is four as depicted in FIG. 4 will be described.
Therefore, in the first embodiment, the total number of the transfer gates TG and the overflow gates OFG is an even number. Further, in the first embodiment, the total number of the transfer gates TG and the total number of the overflow gates OFG are the same number.
Further, the plural overflow gates OFG are arranged point-symmetrically with respect to the optical center OPC at positions different from those of the transfer gates TG as depicted in FIG. 4 when viewed from the incident direction of the light incident on the light receiving element 10.
In the first embodiment, a case where the transfer gates TG and the overflow gates OFG are alternately arranged in a circle with the optical center OPC as the center of the circle when viewed from the incident direction of the light incident on the light receiving element 10, as depicted in FIG. 4, will be described.

<Reset transistor>

As depicted in FIG. 5, the plural reset transistors RST are each connected to a transfer gate TG and a power supply wiring line VDD.
In the first embodiment, as an example, as depicted in FIG. 4, a case where the number of the reset transistors RST is four will be described.
Further, each reset transistor RST turns on or off the discharge of the electric charge accumulated in the floating diffusion FD according to the drive signal supplied from the timing control unit.
Further, the plural reset transistors RST are arranged point-symmetrically with respect to the optical center OPC as depicted in FIG. 4 when viewed from the incident direction of the light incident on the light receiving element 10.

<Amplification transistor>

As depicted in FIG. 5, the plural amplification transistors AMP are each connected to a floating diffusion FD, a power supply wiring line VDD, and a selection transistor SEL.

In the first embodiment, as an example, a case where the number of the amplification transistors AMP is four as depicted in FIG. 4 will be described.

Further, each amplification transistor AMP reads out a potential of the floating diffusion FD reset by the reset transistor RST as a reset level. Further, each amplification transistor AMP amplifies a voltage corresponding to the signal charge accumulated in the floating diffusion FD to which the signal charge is transferred by the transfer gate TG. That is, each amplification transistor AMP reads the signal charge transferred to the floating diffusion FD as an electric signal, and further amplifies the read electric signal.

The voltage (voltage signal) amplified by the amplification transistor AMP is output to a vertical signal line VSL via the selection transistor SEL. Incidentally, the vertical signal line VSL is a wiring line that outputs an electric signal amplified by the amplification transistor AMP. Further, a selection transistor SEL and an A/D converter (not depicted) are connected to the vertical signal line VSL.

Further, the plural amplification transistors AMP are arranged point-symmetrically with respect to the optical center OPC as depicted in FIG. 4 when viewed from the incident direction of the light incident on the light receiving element 10.

<Selection transistor>

As depicted in FIG. 5, the plural selection transistors SEL are each connected to an amplification transistor AMP and a vertical signal line VSL.

In the first embodiment, as an example, a case where the number of the selection transistors SEL is four as depicted in FIG. 4, will be described.

Further, each selection transistor SEL turns on or off the output of the voltage signal from the amplification transistor AMP to the vertical signal line VSL according to the drive signal supplied from the timing control unit.

As a result, each selection transistor SEL becomes conductive by supply of a selection control signal, and selects a unit pixel in synchronization with vertical scanning by a vertical scanning circuit (not depicted).

Further, the plural selection transistors SEL are arranged point-symmetrically with respect to the optical center OPC as depicted in FIG. 4 when viewed from the incident direction of the light incident on the light receiving element 10.

Still further, as depicted in FIG. 4, the configuration included in one pixel is arranged in at least one of a bilaterally symmetric manner and a vertically symmetric manner with respect to one pixel which is the smallest unit. Note that, in the example depicted in FIG. 4, the configurations included in one pixel are a reset transistor RST, an amplification transistor AMP, and a selection transistor SEL.

<Operation timing of transfer gate and overflow gate>

The timing at which each of the transfer gates TG and the overflow gate OFG operates according to the drive signal supplied from the timing control unit is regulated to be the timing depicted in FIG. 6, for example.

To be specific, the transfer gate TGA and the transfer gate TGB that transfer signal charge to the first floating diffusion FDA operate at the same timing. Similarly, the transfer gate TGC and the transfer gate TGD that transfer signal charge to the second floating diffusion FDB operate at the same timing.

Further, the operation performed at the same timing by the transfer gate TGA and the transfer gate TGB, and the operation performed at the same timing by the transfer gate TGC and the transfer gate TGD are opposite operations. That is, at the timing when the transfer gate TGA and the transfer gate TGB transfer the signal charge to the first floating diffusion FDA, the transfer gate TGC and the transfer gate TGD do not transfer the signal charge to the second floating diffusion FDB.

Still further, the timing at which the overflow gate OFG discharges the charge overflowing from the floating diffusion FD is different from the timing at which each transfer gate TG transfers the signal charge to the floating diffusion FD.

<Distance measurement process>

An outline of a distance measurement process by the ToF method will be described.

The ToF method is one of the methods for measuring the distance to an object or measuring the three-dimensional shape of the object. Further, the ToF method is a method of irradiating an object with light and analyzing reflected light to measure the distance (depth) to the object or the shape of the object.

Hereinafter, the outline of the distance (depth) measurement process by the ToF method will be described with reference to FIG. 7. It should be noted that, in the following description, the three-dimensional shape measurement process is not particularly mentioned, but the three-dimensional shape of the object can be obtained by measuring the distances to the object surface over the entire surface of the object.

FIG. 7 depicts the light emitting unit 2, the light receiving element 10 (camera), and an object OBJ. The light output from the light emitting unit 2 is reflected by the object OBJ and is incident on the light receiving element 10.

In this configuration, the distance (depth) d from the light receiving element 10 to the object OBJ can be obtained by measuring time $\Delta t$ until the light output from the light emitting unit 2 and reflected by the object OBJ is incident on the light receiving element 10.

The distance d is calculated using the following Equation 1. Incidentally, in Equation 1, "c" is the speed of light.

$$d = (1/2) \times c \times \Delta t \text{ ... (Equation 1)}$$

It is to be noted that, in FIG. 7, for the sake of clarity, the light emitting unit 2 and the light receiving element 10 are depicted at positions slightly separated from each other. However, in a conventional general device, since a light emitting timing of the light emitting unit 2 and an image capturing timing by the light receiving element 10 are controlled by one clock, the light emitting unit 2 and the light receiving element 10 are located at substantially the same position such as positions in the same device. Therefore, the time $\Delta t$ until the output light from the light emitting unit 2 is reflected by the object OBJ and incident on the light receiving element 10 is the time during which light travels twice the distance (depth) d from the light receiving element 10 to the object OBJ. This is the reason why the value is multiplied by (1/2) in the calculation expression of the distance d in (Equation 1).

However, in the configuration depicted in FIG. 7, the time $\Delta t$ is a very short time, and it is difficult to accurately measure this time $\Delta t$. Therefore, in reality, pulsed light is emitted from the light emitting unit 2, and a time difference of the pulsed light received by the light receiving element 10 is converted into a phase difference to obtain the distance.

This process will be described with reference to FIG. 8.

Also FIG. 8 depicts a light source (light emitting unit) 1, a camera (light receiving unit) 2, and an object OBJ similarly to FIG. 7. The light emitting unit 2 emits pulsed light, and the light receiving element 10 receives the returned pulsed light reflected by the object OBJ.

With this configuration, the time difference between the output pulsed light of the light emitting unit 2 and the input pulsed light of the light receiving element 10 is converted into a phase difference for observation.

The light emitting unit 2 is made to blink at a high speed at a known frequency fHz. That is, one cycle of a light emitting pattern of the light emitting unit 2 is 1/f second. The light receiving element 10 measures a phase of the blinking pattern of light for each pixel. A specific example of the configuration related to phase measurement for each pixel will be described later.

For example, assuming that the difference between the phase of the pulsed light output by the light emitting unit 2 and the phase of the pulsed light received by the light receiving element 10 is $\phi$, the time $\Delta t$ until the output light from the light emitting unit 2 is reflected by the object OBJ and incident on the light receiving element 10 can be calculated using the following (Equation 2).

$$\Delta t = (1/f) \times (\phi/2\pi) \text{ ... (Equation 2)}$$

By substituting the time $\Delta t$ calculated by (Equation 2) into (Equation 1), the distance d from the light receiving element 10 (or the light emitting unit 2) to the object OBJ can be calculated using the following (Equation 3). Incidentally, in (Equation 3), "c" is the speed of light, "$\phi$" is the difference between the phase of the output pulsed light of the light emitting unit 2 and the phase of the received pulsed light of the light receiving element 10, and "f" is the frequency of the pulsed light.

$$d = (c\phi)/4\pi f \text{ ... (Equation 3)}$$

With reference to FIG. 9, a phase calculation configuration of pulsed light for each pixel in the light receiving element 10 will be described.

The light receiving element 10 described with reference to FIGS. 7 and 8 is a ToF camera different from a normal camera, and each pixel repeats ON/OFF at a high speed and accumulates electrification only during the ON period.

In the case of measuring the distance of an object using a ToF camera, the ON/OFF execution timings are sequentially switched to analyze the accumulated charge at each timing. The switching patterns of the ON/OFF execution timing are the following four types depicted in the left figure in FIG. 9, for example.

(C1) Phase 0 degrees
(C2) Phase 90 degrees
(C3) Phase 180 degrees
(C4) Phase 270 degrees

(c1) The phase of 0 degrees is set so that the ON timing (light receiving timing) is the phase of the pulsed light output by the light emitting unit 2, that is, the same phase as (a) light emitting pattern depicted in the left figure of FIG. 4.
(c2) The phase of 90 degrees is set so that the ON timing (light receiving timing) is 90 degrees behind the pulsed light output by the light emitting unit 2 ((a) light emitting pattern).
(c3) The phase of 180 degrees is set so that the ON timing (light receiving timing) is 180 degrees behind the pulsed light output by the light emitting unit 2 ((a) light emitting pattern).
(c4) The phase of 270 degrees is set so that the ON timing (light receiving timing) is 270 degrees behind the pulsed light output by the light emitting unit 2 ((a) light emitting pattern).

In the light receiving element 10, these four types of switching are sequentially executed, and the light receiving amounts while the light receiving timing is varied are acquired. That is, four types of light-receiving amounts of the different accumulation phases and charges corresponding to the light-receiving amounts are obtained.
For example, it is assumed that the charges accumulated when the phase difference of the light receiving pixel with respect to the light emitting pattern is 0, 90, 180, and 270 degrees are set to $Q_0$, $Q_{90}$, $Q_{180}$, and $Q_{270}$, respectively.
Here, the phase difference $\phi$ required to calculate the distance d to the object by applying (Equation 3) is the difference between the phase of the output pulsed light of the light emitting unit 2 and the phase of the received pulsed light of the light receiving element 10.
This phase difference $\phi$ can be calculated based on the following (Equation 4).

$$\phi = \mathrm{Arctan}((Q_{90} - Q_{270})/(Q_{180} - Q_0)) \quad \ldots \text{ (Equation 4)}$$

By substituting the phase difference $\phi$ calculated by (Equation 4), namely, the difference $\phi$ between the phase of the output pulsed light of the light emitting unit 2 and the phase of the received pulsed light of the light receiving element 10 into (Equation 3), the distance d from the light receiving element 10 (or the light emitting unit 2) to the object OBJ can be calculated.
It should be noted that, in the present disclosure, as depicted in FIG. 10, the image frame taken by the ToF camera, namely, the captured image with each phase setting of the amount of phase shift (0 degrees, 90 degrees, 180 degrees, and 270 degrees) from the light emitting pattern (pulse) and the accumulated charge of each captured image are called components.
FIG. 10 is a diagram depicting image data taken by a camera (ToF camera) in accordance with a time axis illustrated from left to right.
The captured images with each phase setting of the amount of phase shift (0, 90 degrees, 180 degrees, and 270 degrees) from the light emitting pattern (pulse) are sequentially and repeatedly captured.
A set of a combination of components with phase settings of 0 degrees, 90 degrees, 180 degrees, and 270 degrees is called a frame.
That is, one frame has the accumulated charge information $Q_0$, $Q_{90}$, $Q_{180}$, and $Q_{270}$ of the captured image set to each phase of 0 degrees, 90 degrees, 180 degrees, and 270 degrees of the phase shift from the light emitting pattern (pulse).
Incidentally, in general, the time between respective components is set shorter than the time between frames.
Next, an outline of a process executed by a ranging device of the present disclosure will be described.
As described with reference to FIGS. 7 to 9, in the distance measurement of an object by the ToF method, it is necessary to detect the phase difference between the light emission pulse of the light source and the light reception pulse of the camera.
In order to accurately detect this phase difference, it is necessary to recognize the ON/OFF timing of the light emission pulse of the light source and the ON/OFF timing of the pixel executed in the camera.
For this purpose, for example, it is sufficient if the ON/OFF timing of the light emission pulse of the light source and the ON/OFF timing of the pixels executed in the camera are controlled based on one clock, that is, the operations are executed in synchronization with each other.

<Photoelectric conversion rate>

It has been demonstrated that the light receiving element 10 of the first embodiment has a high photoelectric conversion rate particularly for light having a low wavelength even if the thickness of the silicon oxide film is increased.

<Action/effect of the first embodiment>

The light receiving element 10 of the first embodiment can exert the following actions and effects.

(1) Plural transfer gates TG which distribute and transfer, to the plural floating diffusions FD, signal charge accumulated in the photodiode PD that photoelectrically converts incident light are provided. In addition to this matter, at least two of the plural transfer gates TG are arranged point-symmetrically with respect to the optical center OPC when viewed from the incident direction of light.
This makes it possible to provide a light receiving element 10 capable of uniformly reducing parasitic light sensitivity.
(2) The number of the transfer gates TG is four, and the four transfer gates TG are arranged at positions that form the vertices of a quadrangle with respect to the optical center OPC when viewed from the incident direction of light.
This makes it easy to secure the distance from the optical center OPC to the floating diffusion FD, and an increase in parasitic light sensitivity can be suppressed.
(3) Plural overflow gates OFG for discharging the charge overflowing from the floating diffusion FD are further provided. In addition to this matter, at least two of the plural overflow gates OFG are arranged point-symmetrically with respect to the optical center OPC when viewed from the incident direction of light.
This makes it possible to provide the light receiving element 10 capable of improving robustness against transfer failure when distributing the charge to each transfer gate TG at a high speed even in the case of misalignment of masks.

That is, the gate type indirect ToF sensor obtains plural phase signals by distributing the electric charge generated by the photodiode PD to the plural floating diffusions FD by the plural transfer gates TG. Further, since ranging is performed using plural phase signals, it is necessary to distribute charge to each transfer gate TG at a high speed, and high robustness against transfer failure is required. Therefore, in the case where the masks are misaligned, there is a problem that the robustness against transfer failure is lowered. In response, in the light receiving element 10 of the first embodiment, at least two of the plural overflow gates OFG are arranged point-symmetrically with respect to the optical center OPC when viewed from the incident direction of the light, and therefore, the above problem can be solved.
Further, since at least two of the plural overflow gates OFG are arranged point-symmetrically with respect to the optical center OPC, in-plane uniformity can be held even in the case where light is reflected by plural transistors.
Further, as compared with a configuration in which the overflow gate OFG is arranged at the optical center OPC, a transfer path for transferring the signal charge to the floating diffusion FD can be configured so as to avoid being divided.
(4) The total number of the transfer gates TG and the overflow gates OFG is an even number.
This makes it possible to suppress the decrease in charge separation efficiency (Cmod) due to process deviation. Further, it becomes easy to maintain point symmetry with respect to the optical center OPC for the plural transfer gates TG and overflow gates OFG.
(5) The total number of the transfer gates TG and the total number of overflow gates OFG are the same.
This makes it possible to suppress complexity of manufacturing professional wrestling.
(6) The optical center OPC is set to one pixel formed by arranging plural unit pixels.
This makes it possible to apply a structure in which the transfer gates TG or the like are arranged point-symmetrically with respect to the optical center OPC when viewed from the incident direction of light for one light receiving element 10, and it becomes possible to reduce the parasitic light sensitivity uniformly.
(7) Plural amplification transistors AMP that read out and amplify signal charge transferred to the floating diffusion FD as an electric signal are further provided. In addition to this, at least two of the plural amplification transistors AMP are arranged point-symmetrically with respect to the optical center OPC when viewed from the incident direction of light.
Due to this, the configuration of the light receiving element 10 can be made highly symmetric, and the quality can be made uniform.
(8) Plural selection transistors SEL for turning on or off the output of the voltage signal from the amplification transistor AMP are further provided. In addition to this matter, at least two of the plural selection transistors SEL are arranged point-symmetrically with respect to the optical center OPC when viewed from the incident direction of light.
As a result, the configuration of the light receiving element 10 can be made highly symmetric, and the quality can be made uniform.

(9) Plural reset transistors RST for turning on or off the discharge of electric charge accumulated in the floating diffusion FD are further provided. In addition to this, at least two of the plural reset transistors RST are arranged point-symmetrically with respect to the optical center OPC when viewed from the incident direction of light.

Due to this, the configuration of the light receiving element 10 can be made highly symmetric, and the quality can be made uniform.

(10) A light-shielding film 20 that carries out light shielding in such a manner that the range of the light incident on the photodiode PD is a preset range is further provided.

As a result, the light reflected by the object and incident on the light receiving element 10 can be allowed to efficiently enter the photodiode PD.

(11) The first semiconductor layer 10A has plural transfer gates TG and plural overflow gates OFG. In addition to this, the second semiconductor layer 10B stacked on the first semiconductor layer 10A in the incident direction of light has plural amplification transistors AMP, plural reset transistors RST, and plural selection transistors SEL.

This makes it possible for the light receiving element 10 having a stacked configuration to uniformly reduce the parasitic light sensitivity. In addition, the configuration of the light receiving element 10 can be diversified.

(12) At least two of the plural transfer gates TG transfer signal charge accumulated in the photodiode PD to one floating diffusion FD.

Due to this, even in the case where a transfer failure of one transfer gate TG occurs, if no transfer failure occurs in the remaining transfer gates TG, as a result, the failure of transfer to one floating diffusion FD can be prevented. Accordingly, even in the case where there is a difference (transfer difference) in the transfer capability (transfer capacity, transfer speed, or the like) of the plural transfer gates TG to one floating diffusion FD, an uttered transfer difference can be canceled.

Further, the configuration of the light receiving element 10 can be made to increase the number of mounted HADs (Hole-Accumulation Diode (registered trademark)), for example, so that the variation in which the HAD is applied can be increased.

(13) An on-chip lens 30 arranged on the side of the photodiode PD where the light is incident thereon is provided.

This makes it possible to suppress variability in sensitivity and color mixing of each color that occur depending on an F value of the on-chip lens 30. This is because, in the light receiving element 10 of the back-illuminated type, the distance between the on-chip lens 30 and a light-receiving surface of the photodiode PD becomes short.

The ranging module 1 of the first embodiment can exert the following actions and effects.

(14) The light receiving element 10, the light emitting unit 2 that emits irradiation light whose brightness fluctuates periodically, and the light emission control unit 4 that controls irradiation timing of the irradiation light are provided.

This makes it possible to provide a ranging module 1 capable of uniformly reducing the parasitic light sensitivity.

(Modification example of the first embodiment)

(1) In the first embodiment, the light receiving element 10 is configured to have plural overflow gates OFG arranged point-symmetrically with respect to the optical center OPC. However, the present invention is not limited to this, and for example, as depicted in FIG. 11, the overflow gate OFG may be arranged at the optical center OPC when viewed from the incident direction of the light.

With this configuration, it is possible to improve process variation resistance with respect to the light receiving element 10.

(2) In the first embodiment, the total number of the transfer gates TG and the total number of the overflow gates OFG are the same, but the number is not limited to this, and for example, as depicted in FIG. 12, the total number of the transfer gates TG and the total number of the overflow gates OFG may be different numbers.

(3) In the first embodiment, at least two of the plural transfer gates TG are configured to transfer signal charge accumulated in the photodiode PD to one floating diffusion FD. However, the present invention is not limited to this, and for example, as depicted in FIGS. 13 to 15, a configuration in which the signal charge accumulated in the photodiode PD is transferred to one floating diffusion FD by one transfer gate TG may be employed. That is, a configuration in which one of the plural transfer gates TG transfers the signal charge accumulated in the photodiode PD to one floating diffusion FD may be employed. Note that, in each of FIGS. 13 to 15, the plural transfer gates are depicted as "a transfer gate TGE, a transfer gate TGF, a transfer gate TGG, and a transfer gate TGH."

With this configuration, a configuration in which the number of floating diffusions FD has been increased can be supported.

(4) In the first embodiment, a configuration is employed in which the first semiconductor layer 10A has transfer gates TG and overflow gates OFG, and the second semiconductor layer 10B has amplification transistors AMP, reset transistors RST, and selection transistors SEL. However, the present invention is not limited to this. That is, for example, as depicted in FIGS. 16 to 18, one semiconductor layer may be configured to have transfer gates TG, overflow gates OFG, amplification transistors AMP, reset transistors RST, and selection transistors SEL.

(5) In the first embodiment, the light receiving element 10 is configured not to have a memory for storing signal charge, but the configuration is not limited to this. That is, for example, as depicted in FIG. 19, the configuration may be one in which the light receiving element 10 further includes plural memories MC for storing signal charge, and at least two of the plural memories MC are arranged point-symmetrically with respect to the optical center OPC when viewed from the incident direction of light.

(6) In the first embodiment, the second semiconductor layer 10B is configured not to have a memory for storing signal charge, but the configuration is not limited to this. That is, for example, as depicted in FIG. 20, the second semiconductor layer 10B may further include plural memories MC for storing signal charge, and at least two of the plural memories MC may be arranged point-symmetrically with respect to the optical center OPC when viewed from the incident direction of light.

(7) In the first embodiment, the light receiving element 10 is configured to have the first semiconductor layer 10A and the second semiconductor layer 10B. However, the present invention is not limited to this, and the light receiving element 10 may be an indirect ToF sensor of the embedded gate type having only one semiconductor layer.

(8) In the first embodiment, the configuration of the light receiving element 10 includes the first semiconductor layer 10A and the second semiconductor layer 10B. However, the configuration is not limited to this, and for example, as depicted in FIG. 21, the configuration of the light receiving element 10 may be one further including a third semiconductor layer 10C. The third semiconductor layer 10C is a layer stacked on the first semiconductor layer 10A and the second semiconductor layer 10B in the incident direction of light at a position farther than the second semiconductor layer 10B from the first semiconductor layer 10A. In this case, the third semiconductor layer 10C has a configuration including plural amplification transistors AMP and plural reset transistors RST. Further, a configuration is employed in which at least two of the plural amplification transistors AMP of the third semiconductor layer 10C are arranged point-symmetrically with respect to the optical center OPC when viewed from the incident direction of light. In addition to this, a configuration is employed in which at least two of the plural reset transistors RST of the third semiconductor layer 10C are arranged point-symmetrically with respect to the optical center OPC when viewed from the incident direction of light.

(9) In the first embodiment, the number of the amplification transistors AMP and the number of the amplification transistors AMP are four, but the number is not limited to this, and for example, as depicted in FIG. 22, the number of the amplification transistors AMP and the number of the amplification transistors AMP may be two.

(10) In the first embodiment, the transfer gates TG and the overflow gates OFG are arranged alternately in a circle centered on the optical center OPC when viewed from the incident direction of the light incident on the light receiving element 10, but the arrangement is not limited to this. That is, for example, as depicted in FIGS. 23 and 24, the transfer gates TG or the overflow gates OFG may be arranged consecutively in a circle centered on the optical center OPC when viewed from the incident direction of the light incident on the light receiving element 10. Incidentally, in FIGS. 23 and 24, the depiction of the transfer gates TG and the overflow gates OFG is simplified for the sake of explanation.

Here, in the configuration depicted in FIG. 23, since the transfer gates TG and the overflow gates OFG are arranged so as to form an octagon when viewed from the incident direction of the light incident on the light receiving element 10, the configuration of the light receiving element 10 can be made highly symmetrical.

Further, in the configuration depicted in FIG. 24, the arrangement of the transfer gates TG is changed in correspondence with the floating diffusion FD that transfers the signal charge, thereby becoming capable of improving stability in a specific direction regarding the transfer of the signal charge.

(11) In the first embodiment, the optical center OPC is set to one pixel formed by arranging plural unit pixels, but the present invention is not limited to this, and the optical center OPC may be set in a pixel group formed by arranging plural pixels.

That is, for example, as depicted in FIGS. 25 to 27, a case where, in one pixel PX, the transfer gates TG and the overflow gates OFG are not arranged point-symmetrically with respect to the center of the pixel PX is considered. Even in this case, by setting the optical center OPC at the center of a quadrilateral in a pixel group PXG, the configuration is arranged in such a manner that the transfer gates TG and the overflow gates OFG are point-symmetrical with respect to the optical center OPC in the pixel group PXG. Note that, in FIGS. 25 to 27, the depiction of the transfer gates TG and the overflow gates OFG is simplified for the sake of explanation. Further, the pixel group PXG is a group of pixels formed by arranging four pixels PX in an array to form a quadrilateral.

With this configuration, the variation can be increased regarding the configuration of the light receiving element 10.

(12) In the first embodiment, as depicted in FIGS. 2 to 4, the light receiving element 10 is configured in such a manner that the first semiconductor layer 10A has a photodiode PD, floating diffusions FD, transfer gates TG, and overflow gates OFG. In addition to this, the configuration of the second semiconductor layer 10B is one having reset transistors RST, amplification transistors AMP, and selection transistors SEL. However, the configurations of the first semiconductor layer 10A and the second semiconductor layer 10B are not limited to these.

That is, for example, a configuration in which grounds GND are arranged in the first semiconductor layer 10A, and grounds GND and power supply wiring lines VDD are arranged in the second semiconductor layer 10B, as depicted in FIGS. 28 to 31 may be employed. It should be noted that FIGS. 28 to 30 depict a configuration of the light receiving element 10 corresponding to one pixel formed by arranging plural (four) unit pixels.

As depicted in FIG. 29, four grounds GND are arranged in the first semiconductor layer 10A. The four grounds GND are arranged at the four respective corners of the first semiconductor layer 10A.

As depicted in FIG. 30, four grounds GND and four power supply wiring lines VDD are arranged in the second semiconductor layer 10B. The four grounds GND are arranged at the respective centers of four edges of the second semiconductor layer 10B. The four power supply wiring lines VDD are arranged at the four respective corners of the second semiconductor layer 10B and are connected to the reset transistors RST.

Then, as depicted in FIG. 31, in the pixel group PXG formed by arranging plural pixels PX (four pixels PX in FIG. 31) in an array, the ground GND located in the first semiconductor layer 10A is shared by two pixels adjacent to each other (not depicted). In addition to this, the ground GND and the power supply wiring line VDD arranged in the second semiconductor layer 10B are shared. It should be noted that, in FIG. 31, in consideration of legibility, addition of reference signs to the configurations other than the pixel PX, the pixel group PXG, the ground GND, and the power supply wiring line VDD is omitted.

With this configuration, the two adjacent pixels PX share the ground GND arranged in the first semiconductor layer 10A, so that miniaturization can be easily achieved. Further, by sharing the ground GND and the power supply wiring line VDD arranged in the second semiconductor layer 10B, miniaturization can be easily achieved.

Further, for example, as depicted in FIGS. 32 and 33, the grounds GND and the power supply wiring lines VDD may be arranged in the first semiconductor layer 10A. Note that FIG. 32 depicts a configuration of the light receiving element 10 corresponding to one pixel formed by arranging plural (four) unit pixels.

As depicted in FIG. 32, four grounds GND and four power supply wiring lines VDD are arranged in the first semiconductor layer 10A. Each of the four grounds GND is arranged closer to the photodiode PD than the four respective edges of the first semiconductor layer 10A are. The four power supply wiring lines VDD are arranged at the four respective corners of the first semiconductor layer 10A and are connected to the reset transistors RST.

Then, as depicted in FIG. 33, in the pixel group PXG formed by arranging plural pixels PX (four pixels PX in FIG. 33) in an array, the power supply wiring line VDD arranged in the first semiconductor layer 10A is shared by two adjacent pixels PX. Incidentally, in FIG. 33, in consideration of legibility, the addition of reference signs to configurations other than the pixel PX, the pixel group PXG, the ground GND, and the power supply wiring line VDD is omitted.

With this configuration, by arranging the ground GND closer to the photodiode PD than an edge of the first semiconductor layer 10A is, the degree of fixation of the ground GND to the first semiconductor layer 10A can be strengthened, and variations that occur in the transfer of electrons can be suppressed. This makes it possible to improve the AC contrast (Cmod) and suppress variations in the AC contrast for each pixel. It should be noted that the "AC contrast" is an index obtained by expressing, as a rate, the accuracy of distributing the electric charge generated by photoelectric conversion to a predetermined floating diffusion FD when the charge is distributed to the plural floating diffusions FD by a modulation drive such as a gate voltage. In addition, as the "AC contrast" is higher, the index becomes better. Note that, as the "Modulation Frequency" corresponding to the modulation frequency of the AC contrast is earlier, more accurate distance measurement becomes possible.

Further, with this configuration, the power supply wiring line VDD arranged in the first semiconductor layer 10A is shared by the two adjacent pixels PX, so that miniaturization can be easily achieved.

Further, for example, as depicted in FIGS. 34 and 35, the grounds GND and the power supply wiring lines VDD may be arranged in the first semiconductor layer 10A. Note that FIG. 34 depicts a configuration of the light receiving element 10 corresponding to one pixel formed by arranging plural (four) unit pixels.

As depicted in FIG. 34, four grounds GND and four power supply wiring lines VDD are arranged in the first semiconductor layer 10A. The four grounds GND are centrally arranged at the four respective edges of the second semiconductor layer 10B. The four power supply wiring lines VDD are arranged at the four respective corners of the first semiconductor layer 10A, and are connected to the reset transistors RST.

Then, as depicted in FIG. 35, in the pixel group PXG formed by arranging plural pixels PX (four pixels PX in FIG. 35) in an array, the ground GND and the power supply wiring line VDD arranged in the first semiconductor layer 10A are shared by two adjacent pixels PX. Incidentally, in FIG. 35, in consideration of legibility, the addition of reference signs to the configurations other than the pixel PX, the pixel group PXG, the ground GND, and the power supply wiring line VDD is omitted.

With this configuration, in two adjacent pixels PX, the ground GND and the power supply wiring line VDD arranged in the first semiconductor layer 10A are shared, so that miniaturization can be easily achieved.

(13) In the first embodiment, as depicted in FIG. 2, the light condensed by the on-chip lens 30 is transmitted through the antireflection layer 40 and made incident on the light-shielding film 20 to be incident on the photodiode PD, but the present invention is not limited to this.

That is, for example, as depicted in FIGS. 36 to 38, a configuration may be employed in which the light condensed by the on-chip lens 30 is scattered by a scattering structure SF and allowed to enter the photodiode PD. Note that FIG. 36 depicts a configuration of the light receiving element 10 corresponding to one pixel formed by arranging plural (four) unit pixels. Incidentally, in FIG. 37, in consideration of legibility, the addition of reference signs to configurations other than the pixel PX, the pixel group PXG, the ground GND, and the power supply wiring line VDD is omitted.

The scattering structure SF is formed by using, for example, a metal material (Metal), a silicon oxide film ($SiO_2$), or the like, and is arranged inside the antireflection layer 40. Further, as depicted in FIG. 36, for example, the scattering structure SF is formed in a plate shape having a uniform thickness when viewed from the direction in which plural unit pixels are arranged. Further, as depicted in FIG. 38, for example, the scattering structure SF is arranged in a grid shape when viewed from the incident direction of the light incident on the light receiving element 10.

With this configuration, the scattering structure SF is arranged point-symmetrically with respect to the optical center such that the light scattered by the scattering structure SF is not biased to a specific transfer gate TG inside the pixel, and thus the bias in sensitivity is suppressed, and the AC contrast can be improved. This makes it possible to improve the sensitivity to the infrared light source, which is the sensitivity emphasized in the indirect ToF.

Incidentally, on a high image height side, which is a side of pixel that is far from an optical axis on the surface of the on-chip lens 30, the light is obliquely incident because the distance from the optical axis is long. Therefore, it is not necessary to arrange the scattering structure SF point-symmetrically with respect to the optical center. Further, the "high image height side" indicates a side on which an image height increases as the location of the image approaches an end of the on-chip lens 30 from the pixel center, which is a portion where diagonal lines of the on-chip lens 30 intersect with each other. Furthermore, the "high image height" refers to sides near the end of the on-chip lens 30 (including any of the upper side, lower side, left side, and right side).

It is to be noted that the configuration of the scattering structure SF is not limited to that depicted in FIG. 38, namely, the configuration in which the structures are arranged in a grid shape when viewed from the incident direction of light incident on the light receiving element 10, and the configurations depicted in FIGS. 39 to 48 may be used.

Besides, the shape of the scattering structure SF is not limited to the configuration depicted in FIG. 36, that is, a plate shape having a uniform thickness when viewed from the direction in which plural unit pixels are arranged.

That is, as depicted in FIG. 49, the shape of the scattering structure SF may be, for example, the shape of a quadrangular pyramid whose apex faces downward (facing the photodiode PD) and whose cross-sectional area decreases as its distance from the photodiode PD decreases. Further, as depicted in FIG. 50, the shape of the scattering structure SF may be, for example, a quadrangular pyramid whose apex faces upward (light incidence side) and whose cross-sectional area decreases as its distance from the photodiode PD increases.

Incidentally, in the case where the shape of the scattering structure SF is the shape depicted in FIG. 49 or 50, the configuration of the scattering structures SF seen from the incident direction of the light incident on the light receiving element 10 is the configuration depicted in FIG. 49, 41, or 48, for example.

(14) In the first embodiment, the overflow gate OFG is connected to the transfer gate TG, but the present invention is not limited to this.

That is, for example, as depicted in FIGS. 51 and 52, a configuration may be adopted in which the overflow gate OFG is arranged at the optical center OPC, and the overflow gate OFG is connected not to the transfer gate TG but to the ground GND. Note that, in FIG. 52, in consideration of legibility, the addition of reference signs to configurations other than the pixel PX, the pixel group PXG, the ground GND, and the overflow gate OFG is omitted.

Further, in the configurations depicted in FIGS. 51 and 52, the configuration of the light receiving element 10 is allowed to have conversion efficiency variable gates FDG.

The conversion efficiency variable gates FDG (polysilicon) are arranged at positions corresponding to optical symmetry and capacitive symmetry, and are connected to the reset transistors RST. Further, the conversion efficiency variable gates FDG function as switches for loading an additional capacitance.

Incidentally, although not depicted, a dummy element may be arranged instead of the conversion efficiency variable gate FDG.

In the configuration depicted in FIGS. 51 and 52, a function similar to that of the overflow gate OFG that receives the drive signal supplied from the timing control unit (not depicted) can be achieved due to a potential barrier formed by the transfer gate TG without supply of the drive signal from the timing control unit. Therefore, in the configuration depicted in FIGS. 51 and 52, charges EC are accumulated in the floating diffusion FD as depicted in FIG. 53B in a state where the transfer gates TG are opened (ON state) as depicted in FIG. 53A. On the other hand, the charges EC are discharged to the overflow gate OFG as depicted in FIG. 54B in a state where the transfer gates TG are closed (OFF state) as depicted in FIG. 54A.

That is, by applying an electric field design in which the charges EC are discharged to the overflow gate OFG with the transfer gates TG in the OFF state, the function equivalent to that of the overflow gate OFG that requires the timing control unit can be achieved without the need for the timing control unit.

With this configuration, the overflow gate OFG, which is a configuration required for indirect ToF, can be easily miniaturized by reducing occupancy of the area inside the pixel while maintaining the symmetry with respect to the optical center OPC.

Further, for example, as depicted in FIGS. 55 and 56, a configuration may be adopted in which the overflow gate OFG is arranged at the optical center OPC and connected to the ground GND, and a transfer electrode VG (Vertical Gate) is further arranged on the transfer gate TG.

Here, the transfer electrode VG is formed by using a vertical type transistor to have a configuration in which a gate electrode (polysilicon) is extended inside a silicon substrate, and connects the transfer gate TG and the photodiode PD. Further, the transfer electrode VG is an electrode created by embedding polysilicon in an excavated portion of a silicon substrate, and for example, two parts which are a part formed in a portion where a silicon substrate is excavated and a part above the silicon substrate are integrally formed. That is, the transfer electrode VG forms an embedded type gate.

In the configuration depicted in FIGS. 55 and 56, the charges EC are accumulated in the floating diffusion FD via the transfer electrode VG in a state where the transfer gates TG are opened (ON state), as depicted in FIG. 57. On the other hand, in a state where the transfer gates TG are closed (OFF state), the charges EC are discharged to the overflow gate OFG via the transfer electrode VG, as depicted in FIG. 58.

With this configuration, it is possible to improve the transfer efficiency of charges EC.

(15) In the first embodiment, the overflow gate OFG is connected to the transfer gate TG, but the present invention is not limited to this.

That is, for example, as depicted in FIGS. 59 and 60, the overflow gate OFG may be arranged at the optical center OPC, and the overflow gate OFG may be connected not to the transfer gate TG but to a photo gate PG. Note that, in FIG. 60, in consideration of legibility, the addition of reference signs to the configurations other than the pixel PX, the pixel group PXG, the ground GND, the overflow gate OFG, and the photo gate PG is omitted.

The photo gate PG is connected to the photodiode PD, and is turned on or off according to a control signal supplied from a drive circuit (not depicted).

In the configuration depicted in FIGS. 59 and 60, the charges EC move to the photo gate PG as depicted in FIG. 61B in a state where the transfer gates TG are opened (ON state), as depicted in FIG. 61A.

On the other hand, the charges EC are discharged to the overflow gate OFG, as depicted in FIG. 62B, in a state where the transfer gates TG are closed (OFF state), as depicted in FIG. 62A.

That is, by applying an electric field design in which the charges EC are discharged to the overflow gate OFG with the transfer gates TG in the OFF state, the function equivalent to that of the overflow gate OFG that requires the timing control unit can be achieved without the need for the timing control unit.

With this configuration, the overflow gate OFG, which is a configuration required for indirect ToF, can be easily miniaturized by reducing the occupancy of the area inside the pixel while maintaining the symmetry with respect to the optical center OPC.

Further, for example, as depicted in FIGS. 63 and 64, a configuration in which the overflow gate OFG may be arranged at the optical center OPC and connected to the photo gate PG, and further the transfer electrode VG may be arranged on the photo gate PG can be employed. Note that, in FIG. 64, the addition of reference signs to the configurations other than the pixel PX, the pixel group PXG, the ground GND, the overflow gate OFG, the photo gate PG, and the transfer electrode VG is omitted in consideration of legibility.

The transfer electrode VG connects the photo gate PG and the photodiode PD.

In the configuration depicted in FIGS. 63 and 64, the charges EC move to the photo gate PG via the transfer electrode VG, as depicted in FIG. 65, in a state where the transfer gates TG are opened (ON state). On the other hand, the charges EC are discharged to the overflow gate OFG via the transfer electrode VG, as depicted in FIG. 66, in a state where the transfer gates TG are closed (OFF state).

With this configuration, it is possible to improve the transfer efficiency of charges EC.

(16) In the first embodiment, as depicted in FIG. 5, the configuration is such that two transfer gates TG are connected to one photodiode PD to form a two-phase circuit, but the configuration is not limited to this.

That is, for example, as depicted in FIG. 67, a configuration may be employed in which four transfer gates TG are connected to one photodiode PD and one overflow gate OFG to form a four-phase circuit.

In the configuration depicted in FIG. 67, the timings at which each transfer gate TG and the overflow gate OFG operate according to the drive signals supplied from the timing control unit are regulated to be those depicted in FIG. 68, for example.

To be specific, the same operations are performed at shifted timings in the order of the transfer gate TGA, the transfer gate TGC, the transfer gate TGB, and the transfer gate TGD. Further, the timing at which the overflow gate OFG discharges charge overflowing from the floating diffusion FD is different from the timing at which each transfer gate TG transfers the signal charge to the floating diffusion FD.

Further, for example, in the case of the configuration depicted in FIG. 52, the four-phase circuit has the configuration depicted in FIG. 69, for example.

In the configuration depicted in FIG. 69, adjacent pixels share the photodiode PD and the overflow gate OFG.

Further, for example, in the case of the configuration depicted in FIG. 60, the four-phase circuit has the configuration depicted in FIG. 70, for example.

In the configuration depicted in FIG. 70, adjacent pixels share the photodiode PD and the overflow gate OFG.

(17) In the first embodiment, the configuration of the first semiconductor layer 10A is one having the photodiode PD, the floating diffusion FD, the transfer gate TG, and the overflow gate OFG, but the configuration is not limited thereto.

That is, for example, as depicted in FIGS. 71 to 73, the first semiconductor layer 10A may have a configuration having plural (four) photo gates PG and plural (four) transfer electrodes VG. In addition to this, a configuration may have a capacitor MIM a part of which is arranged in the first semiconductor layer 10A and the remaining part of which is arranged in the second semiconductor layer 10B.

The photo gate PG is connected to the transfer gate TG.

Further, the four photo gates PG are arranged in a bilaterally symmetric manner and a vertically symmetric manner with respect to one transfer gate TG (for example, transfer gate TGA).

The transfer electrode VG connects the transfer gate TG and the photodiode PD.

As depicted in FIG. 74, the capacitor MIM includes an upper electrode UE, a lower electrode DE, and a high-dielectric-constant film PM.

The upper electrode UE is formed by using a metal material, and has a shape made by bending a flat plate plural times at an angle of approximately 90° when viewed from the direction in which plural unit pixels are arranged, so as to have plural projections and recesses. Further, an upper terminal UT formed linearly using copper is connected to the upper electrode UE.

The lower electrode DE is formed by using a metal material similarly to the upper electrode UE, and is formed in the same shape as the upper electrode UE. Further, a lower terminal DT formed in a plate shape using copper is connected to the lower electrode DE.

The high-dielectric-constant film PM is formed by using an insulator, and is arranged between the upper electrode UE and the lower electrode DE.

In the configuration depicted in FIGS. 71 to 74, the four photo gates PG are arranged in a bilaterally symmetric manner and a vertically symmetric manner with respect to one transfer gate TG. Therefore, the capacities of the four photo gates PG become uniform, and variations in AC contrast for each pixel can be suppressed. In addition to this, the transfer electrode VG that connects the transfer gate TG and the photodiode PD makes it possible to improve electron recovery efficiency in a deep part and improve the AC contrast.

Further, in the configuration depicted in FIGS. 71 to 74, the capacitor MIM having a MIM (Metal-Insulator-Metal) structure in which the high-dielectric-constant film PM is sandwiched between the upper electrode UE and the lower electrode DE has a 3D structure made by folding back a flat plate three-dimensionally. Therefore, an effective area of the capacitor MIM can be increased, and a large amount of electrons can be retained, so that the capacity can be significantly increased.

It is to be noted that, as depicted in FIG. 75, the configuration may be one including eight transfer electrodes VG, so that one transfer gate TG and one photodiode PD are connected by two transfer electrodes VG.

Further, for example, as depicted in FIGS. 76 and 77, the configuration of the light receiving element 10 may be one having plural memories MC, plural photo gates PG, plural transfer electrodes VG, and the capacitor MIM.

It is to be noted that, instead of the configuration depicted in FIGS. 76 and 77, the configuration may have eight transfer electrodes VG, and the two transfer electrodes VG may connect one transfer gate TG and one photodiode PD as depicted in FIG. 78.

Even in the configurations depicted in FIGS. 76 to 78, it becomes possible to suppress variations in AC contrast for each pixel, to improve AC contrast, and to increase the capacity significantly.

Further, the configuration of the photo gate PG is not limited to the configuration in which the photo gate PG is completely arranged inside the first semiconductor layer 10A as depicted in FIGS. 71 and 76.

That is, for example, as depicted in FIGS. 79 and 80, the configuration of the light receiving element 10 may be one having a vertical photo gate VPG.

The vertical photo gate VPG is formed in a shape extending vertically from the first semiconductor layer 10A and embedded in the photodiode PD.

In the configuration depicted in FIGS. 79 and 80, since a part of the vertical photo gate VPG is embedded inside the photodiode PD, it is possible to change the direction of movement of electrons to the intended transfer gate TG among the plural transfer gates TG at a position close to the first semiconductor layer 10A. This makes it possible to improve AC contrast.

(18) In the first embodiment, the configuration of the light receiving element 10 is one having one on-chip lens 30 as depicted in FIG. 2 and the like, but the configuration is not limited to this.

In the configuration including one on-chip lens 30, as depicted in FIGS. 81 to 83, the incident light is condensed toward the overflow gate OFG arranged at the center of the unit pixel. Note that, in FIGS. 81 to 83, the light condensing region which is the region where the incident light is condensed is indicated by a reference sign CR. Note that, in FIG. 83, in consideration of legibility, the addition of reference signs to the configurations other than the pixel PX, the pixel group PXG, the overflow gate OFG, the photo gate PG, and the light condensing region CR is omitted.

On the other hand, in contrast to the configuration including one on-chip lens 30, for example, as depicted in FIGS. 84 to 86, the configuration may include the same number (four) of on-chip lenses 30 as the transfer gates TG. That is, the on-chip lens 30 is divided according to the number of the transfer gates TG arranged in the pixel. Incidentally, in FIG. 86, in consideration of legibility, the addition of reference signs to the configurations other than the pixel PX, the pixel group PXG, the overflow gate OFG, the photo gate PG, and the light condensing region CR is omitted.

In the configuration depicted in FIGS. 84 to 86, the incident light is dispersed into the same number (four) of regions as the on-chip lenses 30. This makes it possible to reduce components of light passing through the overflow gate OFG and improve quantum efficiency.

Further, by making the on-chip lens 30 small as compared with the configuration having one on-chip lens 30, it is possible to increase a curvature of the on-chip lens 30, and to form an image of the collected light on a shallow side from the light incident surface. This makes it possible to reduce components of light that passes through the overflow gate OFG.

Incidentally, although not depicted, the scattering structure SF as depicted in FIG. 36 or the like can also be applied to a configuration including the same number of on-chip lenses 30 as the transfer gates TG.

(First application example)

The technology related to the present disclosure (the present technology) can be applied to various products. For example, the technology according to the present disclosure may be achieved as a device mounted on a moving body of any type of automobiles, electric vehicles, hybrid electric vehicles, motorcycles, bicycles, personal mobility, airplanes, drones, ships, robots, and the like.

FIG. 87 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 87, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 87, an audio speaker 12061, a display section 12062, and an instrument panel 12063 are illustrated as the output device. The display section 12062 may, for example, include at least one of an on-board display and a head-up display.

FIG. 88 is a diagram depicting an example of the installation position of the imaging section 12031.

In FIG. 88, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 88 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

(Other embodiments)

As described above, embodiments of the present technology have been described, but the statements and drawings that form part of this disclosure should not be understood to limit the present technology. This disclosure will reveal to those skilled in the art various alternative embodiments, examples, and operational technologies.

In addition, it goes without saying that the present technology includes various embodiments and the like not described here, such as a configuration in which each configuration described in the above embodiments is applied in a desired manner. Therefore, the technical scope of the present technology is defined only by the matters specifying the invention relating to the reasonable scope of the claims from the above description.

Further, a semiconductor device of the present disclosure does not need to include all of the components described in the above-described embodiments and the like, and may conversely include other components.

It is to be noted that the effects described in the present specification are merely examples and effects of the disclosure are not limited to these, and other effects may be obtained.

It should be noted that the present technology can have the following configurations.

(1) A light receiving element including:

plural transfer gates that distribute and transfer, to plural floating diffusions, signal charge accumulated in a photodiode that photoelectrically converts incident light, in which
at least two of the plural transfer gates are arranged point-symmetrically with respect to an optical center when viewed from an incident direction of the light.

(2) The light receiving element described in the above item (1), in which

the number of transfer gates is four, and
the four transfer gates are arranged at positions forming vertices of a quadrangle with respect to the optical center when viewed from the incident direction of the light.

(3) The light receiving element described in the above item (1) or (2), further including:

an overflow gate that discharges charge overflowing from the floating diffusions, in which
the overflow gate is arranged at the optical center when viewed from the incident direction of the light.

(4) The light receiving element described in the above item (1) or (2), further including:

plural overflow gates that discharge charge overflowing from the floating diffusions, in which
at least two of the plural overflow gates are arranged point-symmetrically with respect to the optical center when viewed from the incident direction of the light.

(5) The light receiving element described in the above item (4), in which the total number of the transfer gates and the overflow gates is an even number.
(6) The light receiving element described in the above item (4) or (5), in which the total number of transfer gates and the total number of overflow gates are identical.
(7) The light receiving element described in any one of the above items (1) to (6), in which the optical center is set to one pixel formed by arranging plural unit pixels.
(8) The light receiving element described in any one of the above items (1) to (6), in which the optical center is set to a pixel group formed by arranging plural pixels.
(9) The light receiving element described in any one of the above items (1) to (8), further including:

plural amplification transistors that read out and amplify the signal charge transferred to the floating diffusions as an electric signal, in which
at least two of the plural amplification transistors are arranged point-symmetrically with respect to the optical center when viewed from the incident direction of the light.

(10) The light receiving element described in any one of the above items (1) to (9), further including:

plural amplification transistors that read out and amplify the signal charge transferred to the floating diffusions as an electric signal; and
plural selection transistors that turn on or off an output of a voltage signal from the amplification transistors, in which
at least two of the plural selection transistors are arranged point-symmetrically with respect to the optical center when viewed from the incident direction of the light.

(11) The light receiving element described in any one of the above items (1) to (10), further including:

plural reset transistors that turn on or off a discharge of charge accumulated in the floating diffusions, in which
at least two of the plural reset transistors are arranged point-symmetrically with respect to the optical center when viewed from the incident direction of the light.

(12) The light receiving element described in any one of the above items (1) to (11), further including:

plural memories that store the signal charge, in which
at least two of the plural memories are arranged point-symmetrically with respect to the optical center when viewed from the incident direction of the light.

(13) The light receiving element described in any one of the above items (1) to (12), further including:
a light-shielding film that performs shielding in such a manner that a range of light incident on the photodiode is a preset range.
(14) A light receiving element including:

a first semiconductor layer having

plural transfer gates that distribute and transfer, to plural floating diffusions, signal charge accumulated in a photodiode that photoelectrically converts incident light, and
plural overflow gates that discharge charge overflowing from the floating diffusions; and

a second semiconductor layer having

plural amplification transistors that read out and amplify the signal charge transferred to the floating diffusions as an electric signal,
plural reset transistors that turn on or off a discharge of charge accumulated in the floating diffusions, and
plural selection transistors that turn on or off an output of a voltage signal from the amplification transistors, in which

the first semiconductor layer and the second semiconductor layer are stacked in the incident direction of the light,
at least two of the plural transfer gates are arranged point-symmetrically with respect to an optical center when viewed from the incident direction of the light,
at least two of the plural overflow gates are arranged point-symmetrically with respect to the optical center when viewed from the incident direction of the light,
at least two of the plural amplification transistors are arranged point-symmetrically with respect to the optical center when viewed from the incident direction of the light,
at least two of the plural reset transistors are arranged point-symmetrically with respect to the optical center when viewed from the incident direction of the light, and
at least two of the plural selection transistors are arranged point-symmetrically with respect to the optical center when viewed from the incident direction of the light.

(15) The light receiving element described in the above item (14), in which

the second semiconductor layer further has plural memories for storing the signal charge, and
at least two of the plural memories are arranged point-symmetrically with respect to the optical center when viewed from the incident direction of the light.

(16) The light receiving element described in the above item (14) or (15), further including:

a third semiconductor layer stacked on the first semiconductor layer and the second semiconductor layer in the incident direction of the light at a position farther than the second semiconductor layer from the first semiconductor layer, in which
the third semiconductor layer includes

plural amplification transistors that read out and amplify the signal charge transferred to the floating diffusions as an electric signal, and
plural reset transistors that turn on or off a discharge of charge accumulated in the floating diffusions,

at least two of the plural amplification transistors of the third semiconductor layer are arranged point-symmetrically with respect to the optical center when viewed from the incident direction of the light, and
at least two of the plural reset transistors of the third semiconductor layer are arranged point-symmetrically with respect to the optical center when viewed from the incident direction of the light.

(17) The light receiving element described in any one of the above items (1) to (16), in which at least two of the plural transfer gates transfer the accumulated signal charge to one of the floating diffusions.
(18) The light receiving element described in any one of the above items (1) to (17), in which one of the plural transfer gates transfers the accumulated signal charge to one of the floating diffusions.
(19) The light receiving element described in any one of the above items (1) to (18), including:
an on-chip lens arranged on a side of the photodiode on which the light is incident on the photodiode.
(20) The light receiving element described in any one of the above items (1) to (19), including:

an on-chip lens arranged on the side of the photodiode on which the light is incident on the photodiode; and
a scattering structure that scatters light condensed by the on-chip lens, in which
light scattered by the scattering structure is incident on the photodiode.

(21) The light receiving element described in the above item (20), in which the scattering structure has a shape in which an area of a cross section decreases as the section becomes closer to the photodiode.
(22) The light receiving element described in the above item (20), in which the scattering structure has a shape in which an area of a cross section decreases as the section becomes farther from the photodiode.
(23) The light receiving element described in any one of the above items (1) to (22), in which a configuration included in one pixel is arranged in at least one of a bilaterally symmetric manner and a vertically symmetric manner with respect to one pixel which is the smallest unit.
(24) The light receiving element described in any one of the above items (1) to (23), including:

plural grounds, in which
at least two of the plural grounds are arranged point-symmetrically with respect to the optical center when viewed from the incident direction of the light.

(25) The light receiving element described in any one of the above items (1) to (24), including:

plural power supply wiring lines, in which
at least two of the plural power supply wiring lines are arranged point-symmetrically with respect to the optical center when viewed from the incident direction of the light.

(26) The light receiving element described in any one of the above items (1) to (25), including:

plural power supply wiring lines, in which
at least two of the plural power supply wiring lines are arranged point-symmetrically with respect to the optical center when viewed from the incident direction of the light.

(27) The light receiving element described in any one of the above items (1) to (26), further including:

an overflow gate that discharges charge overflowing from the floating diffusions; and
a ground, in which
the overflow gate is connected to the ground GND.

(28) The light receiving element described in any one of the above items (1) to (27), further including:
a transfer electrode that connects the transfer gates and the photodiode.
(29) The light receiving element described in any one of the above items (1) to (28), further including:

an overflow gate that discharges charge overflowing from the floating diffusions; and
a photo gate connected to the photodiode, in which
the overflow gate is connected to the photo gate PG.

(30) The light receiving element described in the above item (29), further including:
a transfer electrode that connects the photo gate and the photodiode.
(31) The light receiving element described in any one of the above items (1) to (30), in which the plural transfer gates are connected to the single photodiode.
(32) The light receiving element described in any one of the above items (1) to (30), further including:

plural photo gates connected to the photodiode, in which
the plural photo gates are connected to the single photodiode.

(33) The light receiving element described in any one of the above items (1) to (32), further including:

plural photo gates connected to the photodiode, in which
the plural photo gates are arranged in a bilaterally symmetric manner and a vertically symmetric manner with respect to one of the transfer gates when viewed from the incident direction of the light.

(34) The light receiving element described in any one of the above items (1) to (33), further including:

a first semiconductor layer having

plural transfer gates that distribute and transferring, to plural floating diffusions, signal charge accumulated in a photodiode that photoelectrically converts incident light, and
plural overflow gates that discharge charge overflowing from the floating diffusions;

a second semiconductor layer having

plural amplification transistors that read out and amplify the signal charge transferred to the floating diffusions as an electric signal,
plural reset transistors that turn on or off a discharge of charge accumulated in the floating diffusions, and
plural selection transistors that turn on or off an output of a voltage signal from the amplification transistors; and

a capacitor a part of which is arranged in the first semiconductor layer and the remaining part of which is arranged in the second semiconductor layer, in which
the first semiconductor layer and the second semiconductor layer are stacked in the incident direction of the light, and
the capacitor is formed by sandwiching a high-dielectric-constant film between two electrodes and has a structure made by folding back a flat plate three-dimensionally.

(35) The light receiving element described in any one of the above items (1) to (34), further including:

plural on-chip lenses arranged on the side of the photodiode on which the light is incident on the photodiode, in which
the number of the plural on-chip lenses is the same as that of the plural transfer gates.

(36) A ranging module including:

the light receiving element described in any one of the above items (1) to (35);
a light emitting unit that emits irradiation light whose brightness changes periodically; and
a light emission control unit that controls irradiation timing of the irradiation light.

[Reference Signs List]

| | |
|---|---|
| 1: | Ranging module |
| 2: | Light emitting unit |
| 4: | Light emission control unit |
| 10: | Light receiving element |
| 10A: | First semiconductor layer |
| 10B: | Second semiconductor layer |
| 10C: | Third semiconductor layer |
| 20: | Light-shielding film |
| 30: | On-chip lens |
| 40: | Antireflection layer |
| 12000: | Vehicle control system |
| 12001: | Communication network |
| 12010: | Driving system control unit |
| 12020: | Body system control unit |
| 12030: | Outside-vehicle information detecting unit |
| 12031 | (12101 to 12105): Imaging section |
| 12040: | In-vehicle information detecting unit |
| 12041: | Driver state detecting section |
| 12050: | Integrated control unit |
| 12051: | Microcomputer |
| 12052: | Sound/image output section |
| 12053: | Vehicle-mounted network I/F |
| 12061: | Audio speaker |
| 12062: | Display section |
| 12063: | Instrument panel |
| 12100: | Vehicle |
| 12111 to 12114: | Imaging range |
| PD: | Photodiode |
| FD: | Floating diffusion |
| TG: | Transfer gate |
| OFG: | Overflow gate |
| RST: | Reset transistor |
| AMP: | Amplification transistor |
| SEL: | Selection transistor |
| OPC: | Optical center |
| VDD: | Power supply wiring line |

| | |
|---|---|
| VSL: | Vertical signal line |
| OBJ: | Object |
| MC: | Memory |
| PX: | Pixel |
| PXG: | Pixel group |
| GND: | Ground |
| SF: | Scattering structure |
| EC: | Charge |
| VG: | Transfer electrode |
| PG: | Photo gate |
| MIM: | Capacitor |
| UE: | Upper electrode |
| DE: | Lower electrode |
| PM: | High-dielectric-constant film |
| UT: | Upper terminal |
| DT: | Lower terminal |
| CR: | Light condensing region |

## Claims

**1.** A light receiving element comprising:

plural transfer gates that distribute and transfer, to plural floating diffusions, signal charge accumulated in a photodiode that photoelectrically converts incident light, wherein
at least two of the plural transfer gates are arranged point-symmetrically with respect to an optical center when viewed from an incident direction of the light.

**2.** The light receiving element according to claim 1, wherein

a number of the transfer gates is four, and
the four transfer gates are arranged at positions forming vertices of a quadrangle with respect to the optical center when viewed from the incident direction of the light.

**3.** The light receiving element according to claim 1, further comprising:

an overflow gate that discharges charge overflowing from the floating diffusions, wherein
the overflow gate is arranged at the optical center when viewed from the incident direction of the light.

**4.** The light receiving element according to claim 1, further comprising:

plural overflow gates that discharge charge overflowing from the floating diffusions, wherein
at least two of the plural overflow gates are arranged point-symmetrically with respect to the optical center when viewed from the incident direction of the light.

**5.** The light receiving element according to claim 4, wherein a total number of the transfer gates and the overflow gates is an even number.

**6.** The light receiving element according to claim 4, wherein a total number of the transfer gates and a total number of the overflow gates are identical.

**7.** The light receiving element according to claim 1, wherein the optical center is set to one pixel formed by arranging plural unit pixels.

**8.** The light receiving element according to claim 1, wherein the optical center is set to a pixel group formed by arranging plural pixels.

**9.** The light receiving element according to claim 1, further comprising:

plural amplification transistors that read out and amplify the signal charge transferred to the floating diffusions as an electric signal, wherein
at least two of the plural amplification transistors are arranged point-symmetrically with respect to the optical center when viewed from the incident direction of the light.

**10.** The light receiving element according to claim 1, further comprising:

plural amplification transistors that read out and amplify the signal charge transferred to the floating diffusions as an electric signal; and
plural selection transistors that turn on or off an output of a voltage signal from the amplification transistors, wherein
at least two of the plural selection transistors are arranged point-symmetrically with respect to the optical center when viewed from the incident direction of the light.

**11.** The light receiving element according to claim 1, further comprising:

plural reset transistors that turn on or off a discharge of charge accumulated in the floating diffusions, wherein
at least two of the plural reset transistors are arranged point-symmetrically with respect to the optical center when viewed from the incident direction of the light.

**12.** The light receiving element according to claim 1, further comprising:

plural memories that store the signal charge, wherein
at least two of the plural memories are arranged point-symmetrically with respect to the optical center when viewed from the incident direction of the light.

**13.** The light receiving element according to claim 1, further comprising:

a light-shielding film that performs shielding in such a manner that a range of light incident on the photodiode is a preset range.

**14.** A light receiving element comprising:

a first semiconductor layer including

plural transfer gates that distribute and transfer, to plural floating diffusions, signal charge accumulated in a photodiode that photoelectrically converts incident light, and
plural overflow gates that discharge charge overflowing from the floating diffusions; and

a second semiconductor layer including

plural amplification transistors that read out and amplify the signal charge transferred to the floating diffusions as an electric signal,
plural reset transistors that turn on or off a discharge of charge accumulated in the floating diffusions, and
plural selection transistors that turn on or off an output of a voltage signal from the amplification transistors, wherein

the first semiconductor layer and the second semiconductor layer are stacked in the incident direction of the light,
at least two of the plural transfer gates are arranged point-symmetrically with respect to an optical center when viewed from the incident direction of the light,
at least two of the plural overflow gates are arranged point-symmetrically with respect to the optical center when viewed from the incident direction of the light,
at least two of the plural amplification transistors are arranged point-symmetrically with respect to the optical center when viewed from the incident direction of the light,
at least two of the plural reset transistors are arranged point-symmetrically with respect to the optical center when viewed from the incident direction of the light, and
at least two of the plural selection transistors are arranged point-symmetrically with respect to the optical center when viewed from the incident direction of the light.

**15.** The light receiving element according to claim 14, wherein

the second semiconductor layer further has plural memories for storing the signal charge, and
at least two of the plural memories are arranged point-symmetrically with respect to the optical center when viewed from the incident direction of the light.

**16.** The light receiving element according to claim 15, further comprising:

a third semiconductor layer stacked on the first semiconductor layer and the second semiconductor layer in the incident direction of the light at a position farther than the second semiconductor layer from the first semiconductor layer, wherein
the third semiconductor layer includes

plural amplification transistors that read out and amplify the signal charge transferred to the floating diffusions as an electric signal, and
plural reset transistors that turn on or off a discharge of charge accumulated in the floating diffusions,

at least two of the plural amplification transistors of the third semiconductor layer are arranged point-symmetrically with respect to the optical center when viewed from the incident direction of the light, and
at least two of the plural reset transistors of the third semiconductor layer are arranged point-symmetrically with respect to the optical center when viewed from the incident direction of the light.

**17.** The light receiving element according to claim 1, wherein at least two of the plural transfer gates transfer the accumulated signal charge to one of the floating diffusions.

**18.** The light receiving element according to claim 1, wherein one of the plural transfer gates transfers the accumulated signal charge to one of the floating diffusions.

**19.** The light receiving element according to claim 1, comprising:
an on-chip lens arranged on a side of the photodiode on which the light is incident on the photodiode.

**20.** A ranging module comprising:

the light receiving element according to claim 1;
a light emitting unit that emits irradiation light whose brightness changes periodically; and
a light emission control unit that controls irradiation timing of the irradiation light.

FIG. 1

1
RANGING MODULE
2
LIGHT EMITTING UNIT
LIGHT EMISSION CONTROL SIGNAL CLKp
4
LIGHT EMISSION CONTROL UNIT
IRRADIATION LIGHT
OBJECT
REFLECTED LIGHT
10
LIGHT RECEIVING ELEMENT
DEPTH IMAGE

FIG. 2

10
30
40
20
PD
FDA
FDB
TG
TG
10A
10B

FIG.3

OFG
TGA
TGC
OFG
OFG
PD
OPC
TGD
TGB
OFG
10A

FIG.4

RST
RST
SEL
SEL
AMP
AMP
OPC
AMP
AMP
SEL
SEL
RST
RST
10B

FIG. 5

VDD
VDD
VDD
VDD
RST
OFG
RST
AMP
AMP
PD
TG
TG
SEL
SEL
FDA
FDB
VSL
VSL

FIG. 6

TGA
TGC
TGB
TGD
OFG

FIG.7

OBJ
d
2
10
d= 1/2 cΔt

FIG.8
OBJ
Δt CAN BE CALCULATED AS FOLLOWS WHEN PHASE DEFERENCE = φ
$\Delta t = \frac{1}{f} \times \frac{\varphi}{2\pi}$
DISTANCE d CAN BE CALCULATED AS FOLLOWS
$d = \frac{c\varphi}{4\pi f}$
2
10
1/ f
LIGHT EMITTING PATTERN
TIME
φ : PHASE DIFFERENCE
LIGHT RECEIVING PATTERN
TIME

# FIG. 9

PHASE 0
PHASE 90
PHASE 180
PHASE 270
TIME
1/ f
(a) LIGHT EMITTING PATTERN
ON
OFF
TIME
Δ φ : PHASE DIFFERENCE
(b) LIGHT RECEIVING PATTERN
ON
OFF
TIME
(c1) PHASE 0 DEGREES
ON
OFF
Q0
(c2) PHASE 90 DEGREES
ON
OFF
Q90
(c3) PHASE 180 DEGREES
ON
OFF
Q180
(c4) PHASE 270 DEGREES
ON
OFF
Q270
CALCULATION EXPRESSION FOR PHASE DIFFERENCE φ

$$\varphi = \mathrm{Arc\ tan}\frac{Q_{90} - Q_{270}}{Q_{180} - Q_{0}}$$

# FIG.10

COMPONENT
$Q_0$
$Q_{90}$
$Q_{180}$
$Q_{270}$
FRAME 1
FRAME 2
FRAME 3
TIME = DRIVING TIMING OF ToF CAMERA (SENSOR)

# FIG.11

TGA
OFG
PD
TGD
TGC
OPC
TGB
10A

FIG.12

OFG
TGA
TGC
PD
OPC
TGD
TGB
OFG
10A

FIG.13

OFG
TGE
TGF
OFG
OFG
PD
OPC
TGG
TGH
OFG
10A

# FIG.14

OFG
TGE
TGF
PD
OPC
TGG
TGH
OFG
10A

# FIG.15

TGE
TGF
OFG
PD
OPC
TGG
TGH
10A

FIG.16

SEL
OFG
AMP
RST
RST
TGA
TGC
SEL
PD
OPC
AMP
OFG
OFG
SEL
AMP
TGB
TGD
RST
RST
AMP
OFG
SEL

FIG.17

SEL
OFG
AMP
RST
RST
TGA
TGC
SEL
PD
OPC
AMP
SEL
AMP
TGB
TGD
RST
RST
AMP
OFG
SEL

FIG.18

SEL
AMP
RST
RST
TGA
TGC
SEL
PD
OPC
AMP
OFG
SEL
AMP
TGB
TGD
RST
RST
AMP
SEL

FIG.19

MC
Gate
SEL
OFG
AMP
MC
Gate
RST
RST
TGA
PD
AMP
OFG
SEL
TGB
TGC
SEL
OPC
OFG
AMP
TGD
RST
RST
Gate
AMP
MC
OFG
SEL
Gate
MC

FIG.20

MC
RST
RST
SEL
SEL
AMP
AMP
MC
OPC
AMP
AMP
MC
SEL
SEL
RST
RST
MC
10B

FIG.21

10
30
40
20
PD
FDA
FDB
TG
TG
10A
10B
10C

FIG.22

RST
RST
SEL
AMP
OPC
AMP
SEL
RST
RST
10B

FIG.23

OFG
OFG
TGA
TGC
TGD
TGB
OPC
OFG
OFG

FIG.24

OFG
OFG
TGA
TGB
TGD
TGC
OPC
OFG
OFG

FIG.25

PX
TGA
OFG
OFG
TGB
PX
TGA
TGC
OFG
OFG
OPC
OFG
OFG
TGD
TGC
PX
OFG
TGA
TGB
OFG
PX
PXG

FIG.26

PX
OFG
TGD
TGC
OFG
PX
TGA
OFG
TGB
OFG
OPC
OFG
TGD
OFG
TGC
PX
OFG
TGA
TGB
OFG
PX
PXG

FIG.27

OFG
TGC
OFG
TGB
PX
OFG
TGB
OFG
TGC
PX
TGA
TGD
OFG
OFG
OFG
OFG
TGA
TGD
OPC
TGA
TGD
OFG
OFG
OFG
OFG
TGD
TGA
PX
TGC
OFG
TGC
OFG
PX
TGB
OFG
TGB
OFG
PXG

FIG.28

10
30
40
20
PD
FDA
FDB
GND
GND
TG
TG
10A
10B

FIG.29

OFG
GND
GND
TGA
TGC
OFG
OFG
PD
OPC
TGD
TGB
GND
GND
OFG
10A

FIG.30

GND
VDD
VDD
RST
RST
SEL
SEL
AMP
AMP
OPC
GND
GND
AMP
AMP
SEL
SEL
RST
RST
VDD
VDD
GND
10B

FIG.31

PX
GND
VDD
VDD
GND
GND
PX
VDD
VDD
GND
GND
GND
GND
VDD
VDD
GND
GND
VDD
VDD
PX
GND
VDD
GND
GND
PX
PXG

FIG.32

SEL
GND
AMP
VDD
VDD
TGA
TGC
SEL
PD
OPC
AMP
OFG
GND
GND
SEL
AMP
TGB
TGD
VDD
VDD
AMP
GND
SEL
10A

FIG.33
PX
GND
VDD
GND
VDD
GND
GND
PX
VDD
VDD
GND
GND
GND
GND
VDD
VDD
GND
GND
GND
GND
VDD
VDD
PX
GND
GND
VDD
GND
GND
PX
PXG

FIG.34

SEL
GND
AMP
VDD
VDD
TGA
TGC
SEL
PD
OPC
AMP
OFG
GND
GND
SEL
AMP
TGB
TGD
VDD
VDD
AMP
GND
SEL
10A

FIG.35

PX
GND
VDD
VDD
GND
GND
PX
VDD
VDD
GND
GND
GND
GND
VDD
VDD
GND
GND
VDD
VDD
PX
GND
GND
VDD
GND
PX
PXG

FIG.36

10
SF
SF
SF
30
40
20
PD
FDA
FDB
GND
GND
TG
TG
10A
10B

FIG.37
PX
VDD
VDD
PX
VDD
VDD
VDD
VDD
VDD
VDD
PX
VDD
PX
PXG

FIG.38

PX
SF
PX
SF
SF
PX
SF
PX
PXG

FIG.39

PX
SF
PX
SF
SF
PX
SF
PX
PXG

FIG.40

PX
SF
PX
SF
SF
PX
SF
PX
PXG

FIG.41

PX
SF
PX
SF
SF
PX
SF
PX
PXG

FIG.42

PX
SF
PX
SF
SF
PX
SF
PX
PXG

FIG.43

PX
SF
PX
SF
SF
PX
SF
PX
PXG

FIG.44

PX
SF
PX
SF
SF
PX
SF
PX
PXG

FIG.45

PX
SF
PX
SF
SF
PX
SF
PX
PXG

FIG.46

PX
SF
PX
SF
SF
PX
SF
PX
PXG

FIG.47

PX
SF
PX
SF
SF
PX
SF
PX
PXG

FIG.48

PX
SF
PX
SF
SF
PX
SF
PX
PXG

FIG.49

SF
SF
SF
10
30
40
20
PD
FDA
FDB
GND
GND
TG
TG
10A
10B

FIG.50

SF
SF
SF
10
30
40
20
PD
FDA
FDB
GND
GND
TG
TG
10A
10B

FIG.51

RST
GND FDG
Gate
MC
TGC
SEL
OPC
OFG
GND
AMP
TGD
MC
Gate
Gate
MC
TGA
AMP
GND
SEL
TGB
MC
Gate
FDG
GND
RST
10A

FIG.52

PX
GND
GND
GND
GND
PX
OFG
GND
OFG
GND
GND
GND
GND
GND
GND
GND
GND
GND
OFG
OFG
PX
GND
GND
GND
GND
PX
PXG

FIG.53A

TG
TG
EC
EC
FD
FD
OFG

FIG.53B

10
30
EC
FD
FD
TG
TG
OFG

FIG.54A

TG
TG
EC
EC
FD
FD
OFG

FIG.54B

10
30
EC
FD
FD
TG
TG
OFG

FIG.55

VG
VG
RST
GND
FDG
VG
VG
Gate
MC
TGC
SEL
OPC
OFG
GND
AMP
TGD
MC
Gate
Gate
MC
TGA
AMP
GND
SEL
TGB
MC
Gate
VG
VG
FDG
GND
RST
VG
VG
10A

FIG.56

VG
VG
PX
GND
GND
GND
GND
PX
VG
VG
OFG
OFG
GND
GND
VG
VG
VG
VG
GND
GND
GND
GND
VG
VG
VG
VG
GND
GND
OFG
OFG
VG
VG
PX
GND
GND
GND
GND
PX
VG
VG
PXG

FIG.57

10
30
EC
VG
VG
FD
FD
TG
TG
OFG

FIG.58

10
30
EC
VG
VG
FD
FD
TG
TG
OFG

FIG.59

RST
GND
FDG
Gate
MC
Gate
MC
PGC
SEL
PGA
AMP
OPC
OFG
GND
SEL
PGB
GND
AMP
PGD
MC
Gate
MC
Gate
PD
FDG
GND
RST
10A

FIG.60

PX
GND
GND
GND
GND
PX
OFG
GND
PG
GND
OFG
GND
PG
GND
GND
GND
PG
GND
OFG
PG
GND
OFG
PX
GND
GND
GND
GND
PX
PXG

FIG.61A

TG
TG
EC
EC
PG
PG
OFG

FIG.61B

10
30
EC
MC
MC
PG
PG
OFG

FIG.62A

TG
TG
EC
EC
PG
PG
OFG

FIG.62B

10
30
EC
MC
MC
PG
PG
OFG

FIG.63

VG
RST
GND
FDG
VG
Gate
MC
PGA
AMP
GND
SEL
PGB
MC
Gate
Gate
MC
PGC
SEL
OPC
OFG
GND
AMP
PGD
MC
Gate
VG
FDG
GND
RST
VG
PD
10A

FIG.64

PX
GND
VG
GND
GND
VG
GND
PX
VG
OFG
GND
PG
VG
VG
GND
GND
VG
VG
PG
GND
OFG
VG
PX
GND
VG GND
GND VG
GND
PX
PXG

FIG.65

10
30
EC
VG
VG
MC
MC
PG
PG
OFG

FIG.66
10
30
EC
VG
VG
MC
MC
PG
PG
OFG

FIG.67
VDD
VDD
VDD
VDD
RST
RST
AMP
AMP
SEL
SEL
FDA
TGA
TGC
FDB
OFG
VSL
VSL
PD
VSL
VSL
FDA
TGD
TGB
FDB
SEL
SEL
AMP
AMP
RST
RST
VDD
VDD
VDD
VDD

FIG.68

TGA
TGC
TGB
TGD
OFG

FIG.69

VDD
AMP
SEL
VSL
VDD
RST
TGA
TGC
FDA
FDB
OFG
PD
TGD
TGB

# FIG.70

VDD
AMP
SEL
VDD
RST
PGA
PGC
FDA
FDB
OFG
PD
PGD
PGB
VSL

FIG.71

10
30
40
20
PD
VG
VG
FDA
FDB
GND
GND
TG
TG
PG
PG
10A
10B
10C
MIM

FIG.72

VG
PGA
OFG
PGC
VG
GND
GND
TGA
TGC
OFG
OFG
PD
OPC
TGD
TGB
GND
GND
VG
PGB
OFG
PGD
VG
10A

FIG.73

GND
RST
SEL
AMP
GND
AMP
SEL
RST
RST
SEL
AMP
OPC
GND
AMP
SEL
RST
GND
10B

FIG.74

UE
UT
PM
DE
DT
MIM

# FIG.75

PGA
PGC
VG
OFG
VG
GND
GND
VG
VG
TGA
TGC
OFG
OFG
PD
OPC
VG
VG
TGD
TGB
GND
GND
VG
OFG
VG
PGB
PGD
10A

FIG.76

10
30
40
20
PD
VG
FDA
GND
TG
VG
FDB
GND
TG
10A
10B
PG
MIM
PG

FIG.77

PGA
OFG
PGC
Gate
SEL
GND
AMP
Gate
RST
RST
MC
MC
VG
VG
TGA
TGC
AMP
SEL
OPC
GND
GND
OFG
OFG
SEL
AMP
TGB
TGD
VG
VG
MC
MC
Gate
RST
RST
PGB
PD
GND
SEL
Gate
AMP
OFG
PGD

FIG.78

PGA
OFG
PGC
Gate
SEL
GND
AMP
Gate
RST
RST
MC
MC
VG
VG
TGA
TGC
AMP
SEL
OPC
GND
GND
OFG
OFG
SEL
AMP
TGB
TGD
VG
VG
MC
MC
Gate
RST
RST
PGB
PD
GND
SEL
Gate
AMP
OFG
PGD

FIG.79

10
30
40
20
PD
VPG
FDA
GND
TG
VPG
FDB
GND
TG
10A
10B
MIM

FIG.80

VPGA
OFG
VPGC
Gate
SEL
GND
AMP
Gate
RST
RST
MC
MC
TGA
TGC
AMP
SEL
OPC
GND
GND
OFG
OFG
SEL
AMP
TGB
TGD
MC
MC
Gate
RST
RST
VPGB
PD
GND
SEL
Gate
AMP
OFG
VPGD

FIG.81

10
30
CR
MC
MC
PG
PG
OFG

FIG.82

RST
FDG
CR
Gate
MC
PGC
SEL
OPC
OFG
AMP
PGD
MC
Gate
Gate
MC
PGA
AMP
SEL
PGB
MC
Gate
PD
FDG
RST
10A

FIG.83

PX
CR
CR
PX
OFG
OFG
PG
PG
PG
PG
OFG
OFG
PX
CR
CR
PX
PXG

FIG.84

10
30
30
CR
CR
MC
MC
PG
PG
OFG

FIG.85

CR
RST
FDG
CR
Gate
MC
PGC
SEL
OPC
OFG
AMP
PGD
MC
Gate
Gate
MC
PGA
AMP
SEL
PGB
MC
Gate
CR
PD
FDG
RST
CR
10A

FIG.86

PX
CR
CR
CR
CR
PX
CR
CR
OFG
OFG
PG
PG
CR
CR
CR
CR
CR
PG
PG
OFG
OFG
CR
CR
PX
CR
CR
PX
PXG

FIG.87

12000
12050
INTEGRATED CONTROL UNIT
12051
MICROCOMPUTER
12052
SOUND/IMAGE OUTPUT SECTION
VEHICLE-MOUNTED NETWORK I/F
12053
12061
AUDIO SPEAKER
12062
DISPLAY SECTION
12063
INSTRUMENT PANEL
12001
COMMUNICATION NETWORK
12010
DRIVING SYSTEM CONTROL UNIT
12020
BODY SYSTEM CONTROL UNIT
12030
OUTSIDE-VEHICLE INFORMATION DETECTING UNIT
12040
IN-VEHICLE INFORMATION DETECTING UNIT
12031
IMAGING SECTION
12041
DRIVER STATE DETECTING SECTION

FIG.88

12111
12101
12112
12113
12100
12102
12103
12105
12104
12114

**INTERNATIONAL SEARCH REPORT**

International application No. PCT/JP2020/043269

A. CLASSIFICATION OF SUBJECT MATTER

G01C 3/06(2006.01)i; H01L 27/146(2006.01)i; H04N 5/357(2011.01)i; H04N 5/369(2011.01)i; H04N 5/3745(2011.01)i; G01S 7/487(2006.01)i; G01S 17/89(2020.01)i; G01S 17/93(2020.01)i

FI: H01L27/146 A; H04N5/369; H04N5/3745 200; H04N5/357; H01L27/146 F; G01S7/487; G01S17/89; G01S17/93; G01C3/06 120Q; G01C3/06 140

According to International Patent Classification (IPC) or to both national classification and IPC

B. FIELDS SEARCHED

Minimum documentation searched (classification system followed by classification symbols)

G01C3/06; H01L27/146; H04N5/357; H04N5/369; H04N5/3745; G01S7/487; G01S17/89; G01S17/93

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2019-4149 A (SAMSUNG ELECTRONICS CO., LTD.) 10 January 2019 (2019-01-10) paragraphs [0001], [0017], [0018], [0033], [0044], [0083], fig. 1-26 | 1, 2, 9-11, 18-20<br>13, 19<br>3-8, 12, 14-17 |
| X<br>Y<br>A | JP 2009-47662 A (HAMAMATSU PHOTONICS K.K.) 05 March 2009 (2009-03-05) paragraphs [0001], [0032], [0033], [0045], [0139], [0145], [0148], [0204]-[0207], [0212], [0215], fig. 1-37 | 1, 2, 4-6, 11-13, 18, 20<br>13, 19<br>3, 7-10, 14-17 |
| X<br>Y<br>A | JP 2012-109808 A (HONDA MOTOR CO., LTD.) 07 June 2012 (2012-06-07) paragraphs [0017], [0019], [0020], [0029], [0064], fig. 1-21 | 1-3, 7, 8, 11, 13, 18<br>13, 19<br>4-6, 9, 10 12, 14-17, 20 |

☒ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 28 January 2021 (28.01.2021) | 09 February 2021 (09.02.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/043269

C (Continuation). DOCUMENTS CONSIDERED TO BE RELEVANT

| Category* | Citation of document, with indication, where appropriate, of the relevant passages | Relevant to claim No. |
|---|---|---|
| X<br><br><br>Y<br>A | WO 2017/022220 A1 (PANASONIC IP MANAGEMENT CO., LTD.) 09 February 2017 (2017-02-09) paragraphs [0015], [0016], [0020], [0027], [0031], [0071], [0074], [0083], [0151], fig. 1-26 | 1, 2, 4, 5, 7, 8, 12, 13, 17, 20<br>13, 19<br>3, 6, 9-11, 14-16, 18 |
| P, X | JP 2020-13985 A (SAMSUNG ELECTRONICS CO., LTD.) 23 January 2020 (2020-01-23) paragraphs [0013-[0045], [0078], fig. 1-28 | 1-12, 17, 18, 20 |

Form PCT/ISA/210 (continuation of second sheet) (January 2015)

**INTERNATIONAL SEARCH REPORT**
Information on patent family members

International application No.
PCT/JP2020/043269

| Patent Documents referred in the Report | Publication Date | Patent Family | Publication Date |
|---|---|---|---|
| JP 2019-4149 A | 10 Jan. 2019 | US 2018/0366504 A1 paragraphs [0002], [0038], [0039], [0055], [0066], [0105], fig. 1-10 | |
| JP 2009-47662 A | 05 Mar. 2009 | US 2010/0231891 A1 paragraphs [0001], [0082], [0083], [0095], [0188], [0194], [0197], [0254]-[0257], [0262], [0265], fig. 1-37<br>WO 2009/025373 A1<br>EP 2187237 A1 | |
| JP 2012-109808 A | 07 Jun. 2012 | (Family: none) | |
| WO 2017/022220 A1 | 09 Feb. 2017 | US 2018/0156898 A1 paragraphs [0043], [0044], [0049], [0056], [0061], [0098], [0101], [0111], [0179], fig. 1-26<br>EP 3333893 A1 | |
| JP 2020-13985 A | 23 Jan. 2020 | US 2020/0029047 A1 paragraphs [0036]-[0076], [0111], fig. 1-12 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019001494 A